(19) Europäisches Patentamt
European Patent Office
Office européen des brevets

(11) **EP 2 110 864 A1**

(12) **EUROPEAN PATENT APPLICATION**
published in accordance with Art. 153(4) EPC

(43) Date of publication:
**21.10.2009 Bulletin 2009/43**

(51) Int Cl.:
***H01L 31/108*** (2006.01)   ***H01L 31/105*** (2006.01)
***H01L 31/0224*** (2006.01)

(21) Application number: **07832626.1**

(22) Date of filing: **28.11.2007**

(86) International application number:
**PCT/JP2007/072904**

(87) International publication number:
**WO 2008/075542 (26.06.2008 Gazette 2008/26)**

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **20.12.2006 JP 2006342336**

(71) Applicant: **NEC Corporation**
**Minato-ku**
**Tokyo 108-8001 (JP)**

(72) Inventors:
• **FUJIKATA, Junichi**
  **Tokyo 108-8001 (JP)**
• **OKAMOTO, Daisuke**
  **Tokyo 108-8001 (JP)**
• **MAKITA, Kikuo**
  **Tokyo 108-8001 (JP)**
• **NISHI, Kenichi**
  **Tokyo 108-8001 (JP)**
• **OHASHI, Keishi**
  **Tokyo 108-8001 (JP)**

(74) Representative: **Glawe, Delfs, Moll**
**Patent- und Rechtsanwälte**
**Postfach 26 01 62**
**80058 München (DE)**

(54) **PHOTODIODE, OPTICAL COMMUNICATION DEVICE, AND OPTICAL INTERCONNECTION MODULE**

(57)    Intended is to provide a device structure, which makes the light receiving sensitivity and the high speediness of a photodiode compatible. Also provided is a Schottky barrier type photodiode having a conductive layer formed on the surface of a semiconductor layer. The photodiode is so constituted that a light can be incident on the back side of the semiconductor layer, and that a periodic structure, in which a light incident from the back side of the semiconductor layer causes a surface plasmon resonance, is made around the Schottky junction of the photodiode.

FIG. 1

**Description**

[APPLICABLE FIELD IN THE INDUSTRY]

The present invention relates to a photodiode. The present invention more particularly relates to a photodiode for converting an optical (including infrared-ray light) signal necessary for an information process and a communication field into an electric signal at a high speed. Further, it relates to an optical communication device and an optical interconnection module employing the foregoing photodiode.

[BACKGROUND ART]

It is very attractive from a viewpoint of a cost and a yield to monolithically integrate and circuitize an optical detector. A silicon photoreceiver monolithically integrated and circuitized on a chip identical to that of a CMSO circuit, i.e. a silicon photodiode, is one of attractive substitutes for a hybrid photoreciver (for example, an InGaAs photodiode connected to the CMOS circuit or a GaAs circuit). It is expected that the photoreceiver monolithically integrated and circuitized can be manufactured at a lower cost as compared with the hybrid-designed photoreceiver because it can be manufactured by employing a standard silicon process.

By the way, the photodiode is employed in many cases as a means for converting the optical signal into the electric signal at a high speed. A pin type photodiode is representative thereof. The pin type photodiode has a construction in which an i layer of an intrinsic semiconductor has been put between a p layer of a p-type semiconductor and an n layer of an n-type semiconductor. And, when an inverse bias voltage is applied with a bias power source, almost all region of the i layer having a high resistance becomes a depletion layer of an electric charge carrier. A photon of incident light is mainly absorbed in the i layer to generate electron/positive hole pairs. Each of the generated electron and positive hole drifts within the depletion layer in an opposite direction to the other due to the inverse bias voltage, thereby allowing a current to flow, and is detected as a signal voltage with a load resistance. A circuit time constant that is governed by a product of the load resistance and an electric capacity being produced by the depletion layer can be listed as a factor for putting a limit to a response speed of this photoelectric conversion. Further, a carrier moving time necessary for the electron and the positive hole passing through the depletion layer can be listed as the foregoing factor.

Well, there exists a Schottky type photodiode as a photodiode of which the carrier moving time is short. This photodiode has a construction in which a semitransparent metal film is in contact with the n-layer (or n⁻ layer) of the semiconductor. A Schottky barrier is formed in the neighborhood of an interface in which the n layer (or n⁻ layer) and the semitransparent metal film contact each other. Diffusion of the electron from the semitransparent metal film to the n layer (or n⁻ layer) occurs in the neighborhood of this Schottky barrier, and this region becomes a depletion layer. When the incident light is radiated in this state, the electron is generated in the n layer (or n⁻ layer). This generated electrons drift within the depletion layer due to the inverse bias voltage. And, the light absorption on the element surface layer can be effectively utilized.

By the way, the pin type photodiode necessitates the i layer, i.e. the depletion layer having a sufficient thickness because of absorption of the photon. On the other hand, the depletion layer of the Schottky type photodiode can be made thin. Thus, the Schottky type photodiode can make the carrier movement time short.

Well, an attempt for adopting a lateral electrode structure and making a gap between the electrodes short so as to thin the depletion layer has been made for the pin type photodiode (see Non-patent document 1). This technique, however, is poor in a light absorption efficiency on the surface layer of the semiconductor. Thus, the high sensitivity is difficult to attain even though the high speediness is enabled.

On the other hand, making a value of the load resistance small so as to make the circuit time constant short causes the voltage of a reproduction signal that is takable to lower. Thus, making an S/N of the reproduction signal large, and yet reducing an error in the reading-off necessitates reducing an electric capacity of the depletion layer. In particular, making the depletion layer thin so as to make the carrier moving time short causes the electric capacity to be increased. Thus, it is necessary to reduce the depletion layer (or an area of the Schottky junction) so as to attain the high speediness. However, reducing the foregoing junction area causes a utilization efficiency of the signal light to lower. As a result, the S/N of the reproduction signal deteriorates.

That is the reason why a development for attaining the high speediness/miniaturization by utilizing a metal surface plasmon or a photonic crystal structure is in progress in the photoelectric conversion device of this type.

For example, a metal/semiconductor/metal (MSM) device (optical detector) in which two electrodes have been mounted on an identical surface of the semiconductor have been proposed (Patent document 1). This MSM type optical detector is one kind of the Schottky type photodiodes having the Schottky barrier in the neighborhood of the two electrodes. That is, one part of the light having transmitted through the electrode surface is absorbed in a semiconductor layer (semiconductor absorbing layer) to generate a photocarrier. In such an MSM type optical detector, making the semiconductor thick for a purpose of enhancing a quantum efficiency leads to an increase in a propagation distance of the photocarrier, which causes an operational speed to lower. So as to prevent this operational speed from lowering, the optical detector described in the Patent document 1 has the metal electrode formed along periodic roughness. With this, the incident light is efficiently coupled to the surface plasmon of the metal electrode, and propagates inside the optical detector.

Further, the method has been proposed of manufacturing an MSM type light receiving element having the metal film formed on the semiconductor as a light transmissive insulating film by partially oxidizing it (Patent document 2).

Further, an MSM type light receiving element utilizing proximity field light that occurs in an edge of the metal film existing in both sides of a light transmissive insulating pattern (of which the pattern width is equal to or less than a wavelength of transmission light) has been proposed (Patent document 3). And, it is described that the response speed of this MSM type light receiving element is fast.

Further, the device structure has been proposed in which a positive polarity (metal electrode) and a negative polarity (metal electrode) have been arranged on the semiconductor in such a manner that electrode fingers are intersected with each the other (nested structure) (Patent document 4). This Patent document 4 discloses the technology for coupling the incident light to each of the transmissive light, the reflection light, surface plasmon polariton, etc. with the resonance. In addition hereto, the Patent document 4 teaches that the photocarrier being generated is reinforced owing to the coupling of the incident light and the surface plasmon. However, reducing an irradiation area of the incident light for a purpose of reducing the electric capacity of the depletion layer in these light receiving elements leads to a decline in the intensity of the detection signal, and a decline in the S/N.

Further, a photovoltaic device (a photovoltaic device utilizing solar energy) having periodically-arranged apertures (or concave portions) formed on one of two electrodes holding a plurality of spherical semiconductors each having a pn junction between them has been proposed (Patent document 5). This photovoltaic device is a device for utilizes the resonance of the incident light and the surface plasmon. This Patent document 5, however, does not teach that the depletion layer is made thin and yet the area is made small for a purpose of attaining the high speediness of the photoelectric conversion.

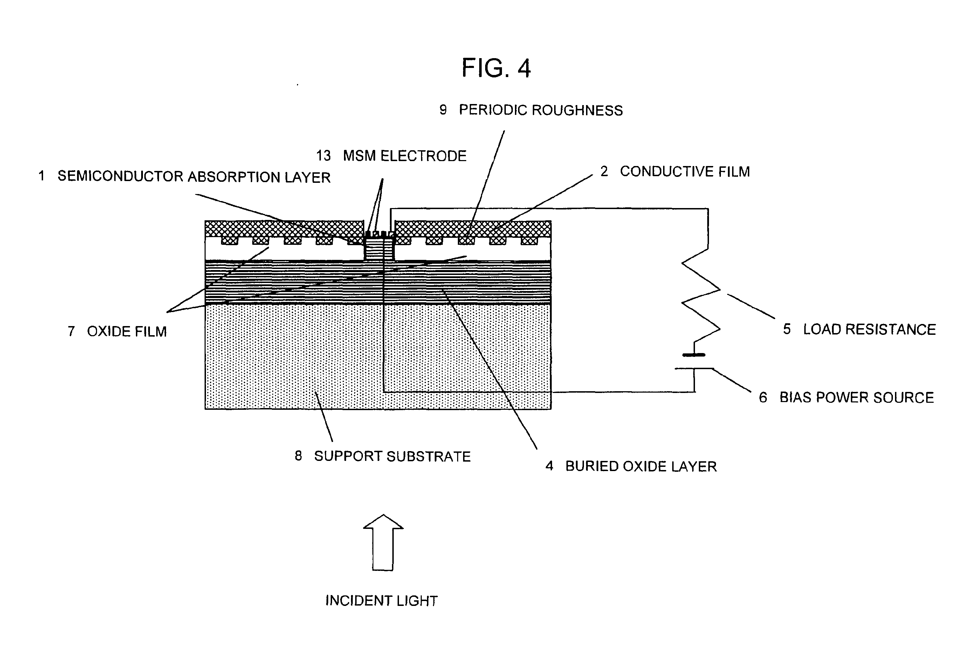

Further, an optical transmitter having an array of periodic grooves formed around the apertures has been proposed (Patent document 6). And, it is reported that the light that propagates is augmented all the more in the optical transmitter having an array of the periodic grooves formed as compared with the case of the optical transmitter having no array of the periodic grooves. However, it is known that total energy of the light that transmits attenuates as compared with the energy of the incident light (Document: Tineke Thio, H.J. Lezec, T. W. Ebbesen, K. M. Pellerin, G. D. Lewen, A. Nahata, and R. A. Linke, "Giant optical transmission of sub-wavelength apertures: physics and applications", Nanotechnology, vol. 13, pp.429-432, Figure 4). For example, the total energy of the light that transmits through the aperture of which the diameter is equal to or less than 40% of a wavelength attenuates to 1% of the incident light energy or less. Thus, the high S/N is not gained even though the light receiving element is irradiated with the propagation light from this optical transmitter.

Further, an MSM type light receiving element having the light absorption layer as a layer having a multilayer film structure in which a photonic band is formed has been proposed (Patent document 7). It is reported that this MSM type light receiving element is high in the light receiving efficiency. However, the point of reducing the junction area in the MSM junction and making the element capacity small has not been realized also in this structure.

Further, a pin type photodiode (a pin type photodiode employing InGaAs) having a microlens formed on the back side of a substrate, and furthermore, a mirror formed for re-reflecting the light incident from the back side, which has been reflected by the element surface, has been proposed (Patent document 8). It is reported that this photodiode is improved in a tolerance of an optical coupling arraignment with external light, and the element coupling area can be made small. However, also in this structure, a diameter of an optical spot focused by the microlens is in the order of several tens of microns, which puts limits to a reduction in the element capacity and to realization of a high-frequency response.

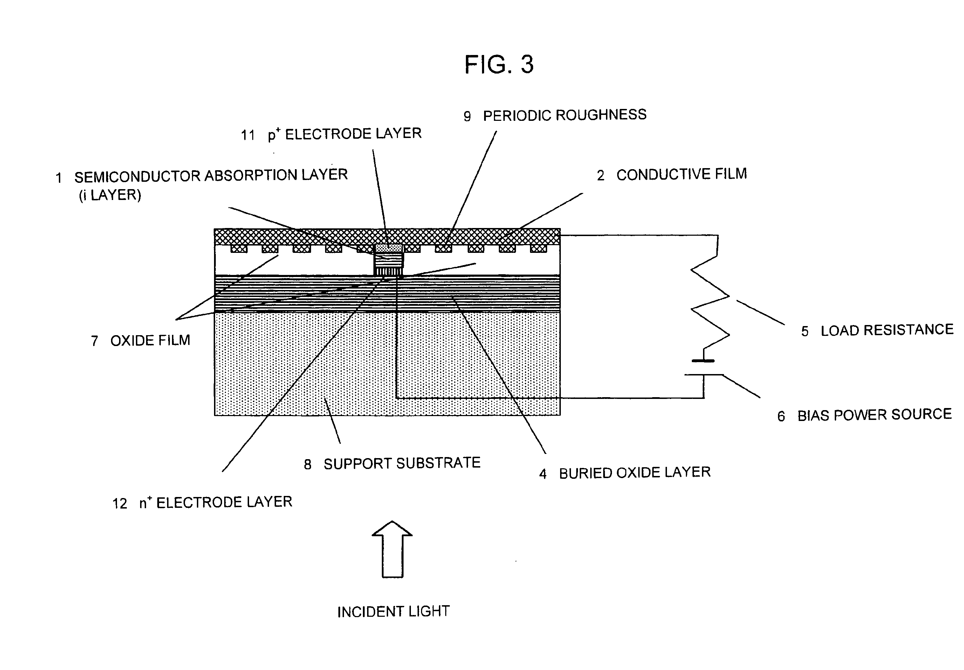

Non-Patent document 1: S. J. Koester, G. Dehlinger, J. D. Schaub, J. O. Chu, Q. C. Quyang, and A. Grill, "Germanium-on-Insulator Photodetectors", 2nd International Conference on Group IV Photonics, FBI 2005 (page 172, Fig. 3)
Patent document 1: JP-P1984-108376A (page 4-16, Fig. 1 to Fig. 3)
Patent document 2: Patent No. 2666888 (page 3-4, Fig. 2)
Patent document 3: Patent No. 2705757 (page 6, Fig. 1)
Patent document 4: JP-P1998-509806A (page 26-33, Fig. 1)
Patent document 5: JP-P2002-76410A (page 6-9, Fig. 1)
Patent document 6: JP-P2000-171763A (page 7-10, Fig. 10, and Fig. 17)
Patent document 7: JP-P2005-150291A (page 5, Fig. 1)
Patent document 8: JP-P1994-77518A (page 2, Fig. 1, and Fig. 2)

[DISCLOSURE OF THE INVENTION]

[PROBLEMS TO BE SOLVED BY THE INVENTION]

The metal-semiconductor-metal (MSM) photodiode offers flatness and compatibility with a silicon LSI.
However, the optical detector employing Si (or SiGe), as a rule, exhibits slow responsiveness because of a long carrier life time (1 to 10 $\mu$s) and a low light absorption ratio (10 to 100/cm).
Further, the Schottky barrier type photodiode, which employs a compound semiconductor, exhibits a fast response.
However, the effective light receiving area becomes small due to the metal electrode. Thus, the sensitivity lowers.
Further, the lateral electrode structure has been proposed for the pin type photodiode for a purpose of layer-thinning the depletion layer.
However, the high sensitivity is difficult to attain even though the high speediness can be attained by making a distance between the electrodes small.
And, making the response of the photodiode fast necessitates thinning the light absorption layer, thereby to make the carrier moving time short, or making the light receiving area, namely, the junction capacity small, thereby to make the circuit time constant small.
However, as a rule, the light receiving sensitivity and the high speediness are in a relation of trade-off with each other.
Thus, the present invention has been accomplished in order to solve the above-mentioned problems, and an object thereof is to provide a device structure capable of making the light receiving sensitivity and the high speediness of the photodiode compatible with each other. In particular, an object thereof is to provide a photodiode that realizes high integration and low power consumption by accomplishing the light absorption layer of which the volume is smaller by two digits or more as compared with that of the conventional light absorption layer.

[MEANS FOR SOLVING THE PROBLEM]

The foregoing problems are solved by a Schottky barrier type photodiode having a conductive layer formed on a surface of a semiconductor layer, which is characterized in configured so that the light can be incident on the back side of the semiconductor layer, wherein a periodic structure in which the light incident from the back side of the semiconductor layer causes a surface plasmon resonance is made around a Shcottky junction of the foregoing photodiode.
Further, the foregoing problems are solved by a p-i-n type photodiode having a p-i-n type junction formed on a surface of a semiconductor layer, which is characterized in configured so that the light can be incident on the back side of the semiconductor layer, wherein a conductive layer is formed, and a periodic structure in which the light incident from the back side of the semiconductor layer causes a surface plasmon resonance is made around the p-i-n junction of the foregoing photodiode.
Further, the foregoing problems are solved by a photodiode having metal-semiconductor-metal junctions intervally arranged on a surface of a semiconductor layer, wherein the foregoing photodiode is configured so that the light can be incident on the back side of the semiconductor layer, and wherein a conductive layer is formed, and a periodic structure in which the light incident from the back side of the semiconductor layer causes a surface plasmon resonance is made around the metal-semiconductor-metal junction of the foregoing photodiode.
Further, the foregoing problems are solved by an optical communication device having the foregoing photodiode formed on a light receiving portion thereof.
Further, the foregoing problems are solved by an optical interconnection module, which includes: a Si substrate having the above-mentioned photodiode configured thereon; and an LSI electronic circuit formed monolithically with the foregoing photodiode on the foregoing Si substrate.

[AN ADVANTAGEOUS EFFECT OF THE INVENTION]

Making the response of the photodiode fast necessitates thinning the electric charge carrier absorption layer, thereby to make the carrier moving time short, and yet making the area of the electric charge carrier absorption layer small, thereby to make the circuit time constant small. However, conventionally, it has been difficult to make the sensitivity and the high speediness compatible.
On the other hand, the present invention focuses the optical energy into a region equal to or less than a wavelength in size, and efficiently converts this into a photocarrier, thereby to gain an electric signal. As a result, compatibility of the sensitivity and the high speediness is realized. And, the fast and high-efficiency photodetector is realized.

[BRIEF DESCRIPTION OF THE DRAWINGS]

[Fig. 1] Fig. 1 is a cross sectional view of the photodiode of a first example.
[Fig. 2] Fig. 2 is a cross sectional view of the photodiode of a second example.
[Fig. 3] Fig. 3 is a cross sectional view of the photodiode of a third example.
[Fig. 4] Fig. 4 is a cross sectional view of the photodiode of a fourth example.
[Fig. 5] Fig. 5 is a plan of the photodiode.
[Fig. 6] Fig. 6 is a plan of the photodiode.
[Fig. 7] Fig. 7 is a plan of the photodiode.
[Fig. 8] Fig. 8 is a plan of the photodiode.
[Fig. 9] Fig. 9 is a plan of the photodiode.
[Fig. 10] Fig. 10 is a plan of the photodiode.
[Fig. 11] Fig. 11 is a graph illustrating a special feature of the photodiode of the first example.
[Fig. 12] Fig. 12 is a manufacturing process view of the photodiode.
[Fig. 13] Fig. 13 is a graph illustrating a special feature of the photodiode of the second example.
[Fig. 14] Fig. 14 is a graph illustrating a special feature of the photodiode of the third example.
[Fig. 15] Fig. 15 is a plan of the photodiode of the fourth example.
[Fig. 16] Fig. 16 is a graph illustrating a special feature of the photodiode of the fourth example.
[Fig. 17] Fig. 17 is a cross sectional view of the photodiode of a fifth example.
[Fig. 18] Fig. 18 is a cross sectional view of the photodiode of a sixth example.
[Fig. 19] Fig. 19 is a cross sectional view of the photodiode of a seventh example.
[Fig. 20] Fig. 20 is a cross sectional view of the photodiode of an eighth example.
[Fig. 21] Fig. 21 is a schematic view of a light receiving module for transmission having the Schottky type photodiode of the present invention installed therein.
[Fig. 22] Fig. 22 is a schematic view of a LSI intra-chip optical interconnect having the photodiode of the present invention installed therein.

[DESCRIPTION OF NUMERALS]

1 semiconductor absorption layer
2 conductive film
3 lower electrode layer
4 buried oxide layer
5 load resistance
6 bias power source
7 oxide film
8 support substrate
9 periodic roughness
10 Schottky contact layer
11 metal film
12 n+ electrode layer
13 MSM electrode
14 forbidden band grating for preventing plasmon resonance from being generated
15 projected shape
16 grooved shape
17 periodic slit array or minute aperture array
18 Schottky contact layer
19 electrode pad
20 optical fiber
21 signal light
22 photodiode of the present invention
23 module frame
24 electric wiring
25 preamp carrier

26 chip carrier
27 VCSEL light source
28 electric wiring via for light source and modulation
29 electric wiring via for photodiode
30 LSI package
31 electric wiring layer for a light source and a modulation
32 electric wiring layer for photodiode
33 optical signal output fiber
34 optical signal input fiber
35 LSI-installed board
36 concave mirror
37 photodiode/light source-installed board

[BEST MODE FOR CARRYING OUT THE INVENTION]

A first photodiode in accordance with the present invention is a Schottky barrier type photodiode having a conductive layer formed on a surface of a semiconductor layer. The foregoing photodiode is configured so that the light can be incident on the back side of the foregoing semiconductor layer. The periodic structure in which the light incident from back side of the foregoing semiconductor causes the surface plasmon resonance is made around the Schottky junction of the foregoing photodiode.

A second photodiode in accordance with the present invention is a p-i-n type photodiode having a p-i-n type junction formed on a surface of a semiconductor layer. The foregoing photodiode is configured so that the light can be incident on the back side of the foregoing semiconductor layer. The conductive layer is formed, and the periodic structure in which the light incident from back side of the foregoing semiconductor layer causes the surface plasmon resonance is made around the p-i-n junction of the foregoing photodiode.

A third photodiode in accordance with the present invention is a photodiode having metal-semiconductor-metal junctions intervally arranged on a surface of a semiconductor layer. The foregoing photodiode is configured so that the light can be incident on the back side of the foregoing semiconductor layer. The conductive layer is formed, and the periodic structure in which the light incident from back side of the foregoing semiconductor layer causes the surface plasmon resonance is made around the metal-semiconductor-metal junction of the foregoing photodiode.

A fourth photodiode in accordance with the present invention is a photodiode that is obtained by particularly configuring the above-mentioned third photodiode as follows. A gap between the metal-semiconductor-metal junctions arranged on the surface of the semiconductor layer is equal to or less than $\lambda/n$ (where $\lambda$ is a wavelength of the light incident from the back side of the semiconductor layer, and n is a refractive index of the light in the semiconductor layer). The foregoing metal layer is a layer in which a metal layer forming the Schottky junction with the foregoing semiconductor, and a layer comprised of conductive materials capable of inducing the surface plasmon have been laminated. Or, the foregoing metal layer is a metal layer capable of forming the Schottky junction with the foregoing semiconductor, and yet of inducing the surface plasmon.

A fifth photodiode in accordance with the present invention is a photodiode that is obtained by particularly configuring the above-mentioned third or fourth photodiode as follows. With respect to the foregoing metal-semiconductor-metal junction, at least one of the metal-semiconductor junctions facing each other is a Schottky barrier type junction.

A sixth photodiode in accordance with the present invention is a photodiode that is obtained by particularly configuring any of the above-mentioned first to fifth photodiodes as follows. The periodic structure for causing the surface plasmon resonance is a structure in which the conductive layers capable of inducing the surface plasmon have been laminated on the surface of the semiconductor layer having the roughness formed thereon.

A seventh photodiode in accordance with the present invention is a photodiode that is obtained by particularly configuring any of the above-mentioned first to sixth photodiodes as follows. The periodic structure for causing the surface plasmon resonance is a structure in which the conductive layers capable of inducing the surface plasmon have been laminated on the surface of the dielectric layer having the roughness formed thereon.

An eighth photodiode in accordance with the present invention is a photodiode that is obtained by particularly configuring any of the above-mentioned first to seventh photodiodes as follows. The periodic structure for preventing the surface plasmon from being generated is made outside the periodic structure for causing the surface plasmon resonance.

A ninth photodiode in accordance with the present invention is a photodiode that is obtained by particularly configuring any of the above-mentioned first to eighth photodiodes as follows. The stepped structure for reflecting the surface plasmon is made outside the periodic structure for causing the surface plasmon resonance.

A tenth photodiode in accordance with the present invention is a photodiode that is obtained by particularly configuring the above-mentioned ninth photodiode as follows. The stepped structure is comprised of a projected shape higher than $\lambda/n_d$ (where $n_d$ is a refractive index of the light in the semiconductor layer or the dielectric layer neighboring the conductive film, and $\lambda$ is a wavelength of the light).

An eleventh photodiode in accordance with the present invention is a photodiode that is obtained by particularly configuring the above-mentioned ninth or tenth photodiode as follows. The stepped structure is comprised of a grooved shape deeper than $\lambda/n_d$ (where $n_d$ is a refractive index of the light in the semiconductor layer or the dielectric layer neighboring the conductive film, and $\lambda$ is a wavelength of the light).

A twelfth photodiode in accordance with the present invention is a photodiode that is obtained by particularly configuring any of the above-mentioned ninth to eleventh photodiodes as follows. The stepped structure is comprised of a shape in which bores formed on the conductive material, of which the diameter is equal to or less than the wavelength of the incident light, have been arrayed.

A thirteenth photodiode in accordance with the present invention is a photodiode that is obtained by particularly configuring any of the above-mentioned ninth to twelfth photodiodes as follows. The stepped structure is comprised of a shape in which slits formed on the conductive material, of which the width is equal to or less than the wavelength of the incident light, have been arrayed.

A fourteenth photodiode in accordance with the present invention is a photodiode that is obtained by particularly configuring any of the above-mentioned ninth to thirteenth photodiodes as follows. The conductive layer is made of at least one metal (or alloy) selected from a group consisting of Al, Ag, Au, and Cu.

A fifteenth photodiode in accordance with the present invention is a photodiode that is obtained by particularly configuring any of the above-mentioned first to fourteenth photodiodes as follows. The junction area in the photodiode is 100 square microns or less.

A sixteenth photodiode in accordance with the present invention is a photodiode that is obtained by particularly configuring any of the above-mentioned first to fourteenth photodiodes as follows. The junction area in the photodiode is 10 square microns or less.

A seventeenth photodiode in accordance with the present invention is a photodiode that is obtained by particularly configuring any of the above-mentioned first to fourteenth photodiodes as follows. The junction area in the photodiode is one square micron or less.

An eighteenth photodiode in accordance with the present invention is a photodiode that is obtained by particularly configuring any of the above-mentioned first to seventeenth photodiodes as follows. The thickness of the semiconductor absorption layer in the photodiode is 1 $\mu$m or less.

A nineteenth photodiode in accordance with the present invention is a photodiode that is obtained by particularly configuring any of the above-mentioned first to seventeenth photodiodes as follows. The thickness of the semiconductor absorption layer in the photodiode is 200 nm or less.

A twentieth photodiode in accordance with the present invention is a photodiode that is obtained by particularly configuring any of the above-mentioned first to nineteenth photodiodes as follows. The semiconductor absorption layer in the photodiode is made of at least one member selected from a group consisting of Si, SixGe1-x (where x is a positive number smaller than 1), Ge, GaN, GaAs, GaInAs, GaInP, and InP.

A twenty-first photodiode in accordance with the present invention is a photodiode that is obtained by particularly configuring any of the above-mentioned first to twentieth photodiodes as follows. The semiconductor absorption layer in the photodiode is made of at least one member selected from a group consisting of Ge and SixGe1-x (where x is a positive number smaller than 1). And, the layer that is configured of an alloy of Ni and Ge is formed between the foregoing semiconductor absorption layer and conductive layer.

A twenty-second photodiode in accordance with the present invention is a photodiode that is obtained by particularly configuring any of the above-mentioned first to twenty-first photodiodes as follows. The photodiode is configured on an optical waveguide comprised of the semiconductor.

A twenty-third photodiode in accordance with the present invention is a photodiode that is obtained by particularly configuring any of the above-mentioned first to twenty-first photodiodes as follows. The photodiode is configured so that it can receive the light coming from the optical waveguide formed in the substrate side, which has been reflected by the mirror.

A twenty-fourth photodiode in accordance with the present invention is a photodiode that is obtained by particularly configuring any of the above-mentioned first to twenty-third photodiodes as follows. The substrate of the photodiode is configured of the material transparent to the incident light.

Furthermore, the photodiode in accordance with the present invention will be explained in details.

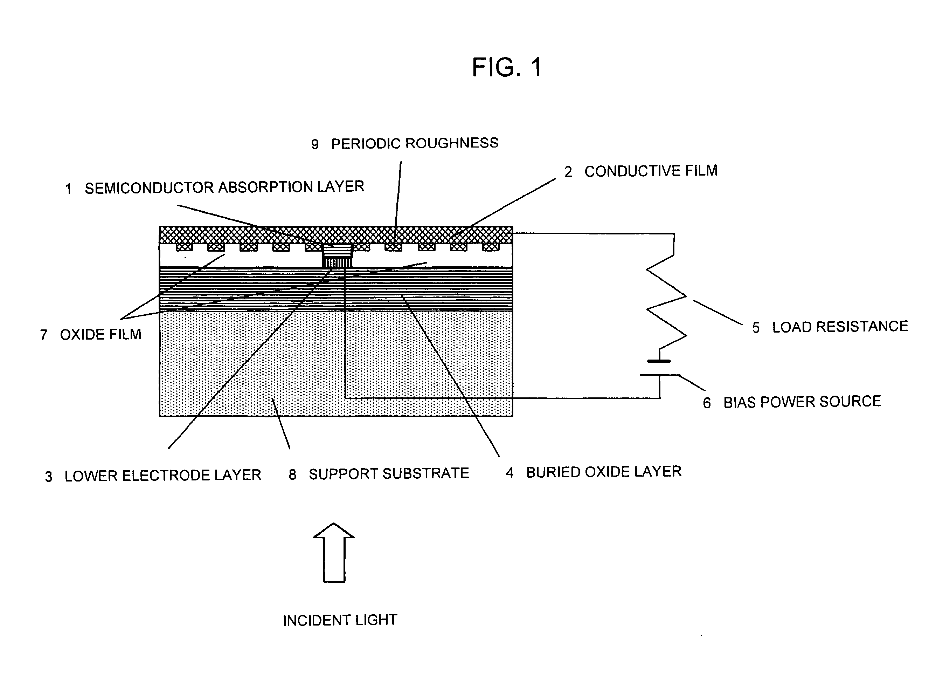

The first photodiode in accordance with the present invention is a Schottky barrier type photodiode having the conductive film formed on the surface of the semiconductor layer. And, the first photodiode is configured so that the light can be incident on the back side of the semiconductor layer. The circumference of the foregoing Schottky junction has the periodic structure in which the light incident from the back side of the foregoing semiconductor layer causes the surface plasmon resonance. This leads to an increase in an efficiency of the optical coupling with the light incident from the back side of the semiconductor layer. This structure is shown in Fig. 1. That is, as shown in Fig. 1, a conductive film 2 is formed on the surface of a semiconductor layer (semiconductor absorption layer) 1. With this, the Schottky junction is configured. The periodic structure in which the light incident from the back side (support substrate 8 side) of the semiconductor layer (semiconductor absorption layer) 1 causes the surface plasmon resonance, i.e. a periodic roughness structure 9 is made around this Schottky junction.

And, the light incident from the back side of the support substrate 8 is converted into the surface plasmon due to the periodic roughness structure 9 for causing the surface plasmon resonance, and is focused into the Schottky junction existing in the central portion. In addition hereto, the circumference of the semiconductor absorption layer 1 has been established as a semiconductor layer (or dielectric layer) of which the refractive index is lower than that of the semiconductor absorption layer 1. With this refractive index difference, the light is entrapped. That is, this entrapment effect of the light causes the optical power incident in the semiconductor absorption layer 1 to be localized in the minute Schottky junction region. As a result, the efficient photoelectric conversion is attained in the semiconductor absorption layer having a very small volume.

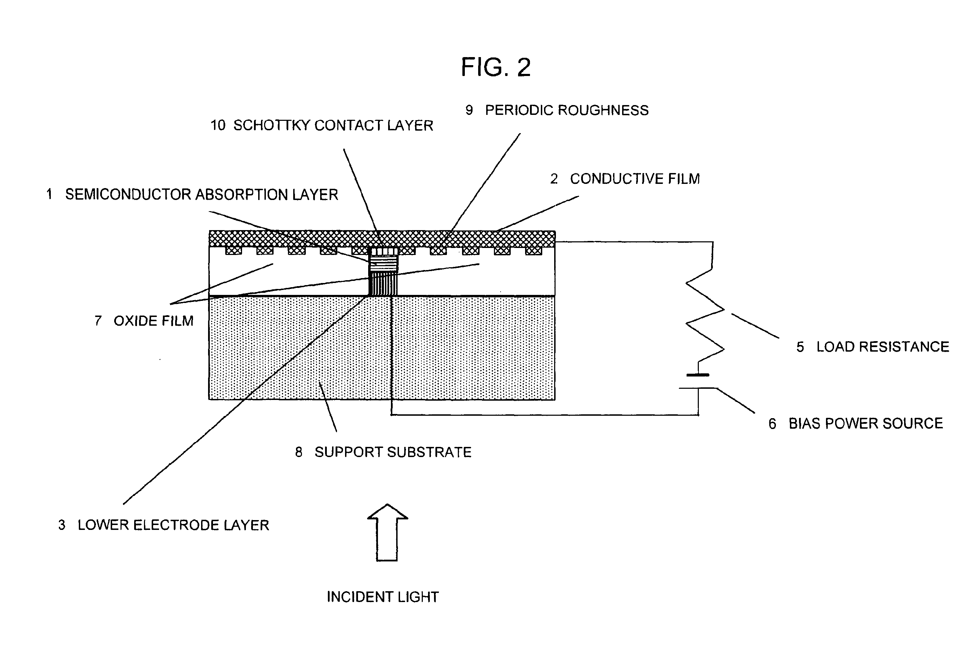

Fig. 2 shows the structure of the photodiode in which a Schottky contact layer (semiconductor layer for Schottky junction (or metal layer for realizing sufficient Schottky barrier energy)) 10 has been formed on the surface of the semiconductor layer (semiconductor absorption layer) 1, and the conductive film 2 has been formed on this Schottky contact layer 10.

In this photodiode, the periodic roughness structure (the periodic structure in which the light incident from the back side of the semiconductor layer (semiconductor absorption layer) 1 causes the surface plasmon resonance) 9 is made around the Schottky junction.

Herein, in the case of employing Ge or InGaAs compound semiconductor for the material of the semiconductor layer (semiconductor absorption layer) 1, directly laminating Ag and Au as a conductive film does not lead to formation of the Schottky junction. Thus, a leak current becomes large. Thereupon, in the case of employing these materials, for example, a Ge semiconductor absorption layer, the metal layer (or Si layer) such as a Ni layer, in which the junction having high Schottky barrier energy is gained, is desirably inserted into the interface between the conductive film and the semiconductor absorption layer (for example, the Ge layer). In the case of employing InGaAs as a material of the semiconductor absorption layer 1, inserting an InALAs semiconductor layer makes it possible to form the Schottky junction in which a leak current is few.

The second photodiode in accordance with the present invention is a photodiode having a p-i-n type junction formed on the surface of a semiconductor layer. And, the second photodiode is configured so that the light can be incident on the back side of the foregoing semiconductor layer. The conductive layer is formed, and the periodic structure 9 in which the light incident from the back side of the foregoing semiconductor layer causes the surface plasmon resonance is made around the p-i-n junction of the foregoing photodiode. This periodic structure 9 is a periodic roughness structure in which the light incident from the back side ($n^+$ electrode layer 12: support substrate 8 side) of the semiconductor layer (semiconductor absorption layer: i layer) 1 causes the surface plasmon resonance. This leads to an increase in an efficiency of the optical coupling with the light incident from the back side of the semiconductor layer. This structure is shown in Fig. 3. That is, as shown in Fig. 3, the conductive film 2 is formed on the surface of the semiconductor layer (semiconductor absorption layer: i layer) 1. And, the light incident from the back side of the support substrate 8 is converted into the surface plasmon due to the roughness structure 9 formed around the p-i-n junction, and focused into the p-i-n junction existing in the central portion. In addition hereto, the circumference of the semiconductor absorption layer 1 has been desirably established as a semiconductor layer (or dielectric layer) of which the refractive index is lower than that of the semiconductor absorption layer 1. With this refractive index difference, the light is entrapped. That is, this entrapment effect of the light enables the power of the incident light to be localized in the p-i-n junction existing in the central portion. With this, the efficient photoelectric conversion is attained in the semiconductor absorption layer 1 having a very small volume. In addition hereto, laminating a $p^+$ electrode layer 11 and the conductive film 2 enables the conductive film 2 to be used as both of an antenna for the plasmon resonance and an electrode. And yet, configuring the $p^+$ electrode layer 11 (and/or the $n^+$ electrode layer 12) by employing the semiconductor having a band gap larger than the energy of the light received in the semiconductor absorption layer (i layer) 1 makes it possible to reduce a light absorption loss in the electrode layer 11 (12). As a result, an efficiency of the photoelectric conversion can be improved all the more.

The third photodiode in accordance with the present invention is a photodiode having metal-semiconductor-metal (MSM) junctions intervally arranged on the surface of a semiconductor layer. And, the third photodiode is configured so that the light can be incident on the back side of the semiconductor layer. The conductive layer is formed, and the periodic structure in which the light incident from the back side of the foregoing semiconductor layer causes the surface plasmon resonance is made around the foregoing MSM junction. This leads to an increase in an efficiency of the optical coupling with the light incident from the back side of the semiconductor layer. This structure is shown in Fig. 4. That is, an MSM electrode 13 is formed on the surface of the semiconductor layer (semiconductor absorption layer) 1. The conductive film 2 is formed around this MSM electrode 13. Yet, around this MSM electrode 13, the periodic roughness structure (the periodic structure in which the light incident from the back side (support substrate 8 side) of the semiconductor layer (semiconductor absorption layer) 1 causes the surface plasmon resonance) 9 is made.

Conventionally, the metal electrode formed on the semiconductor surface causes the light receiving sensitivity to lower because it blocks the light receiving surface of the photodiode. Also even though the electrode interval for causing the surface plasmon resonance is established, the region in which optical electric field intensity is strong exists outside the semiconductor. Thus, the photocarrier cannot be generated efficiently.

On the other hand, by making a configuration so that the light is incident from the back side of the semiconductor absorption layer 1, and the periodic roughness structure 9 exists around the MSM junction (MSM electrode 13), the light is effectively focused into the minute MSM junction. In addition hereto, the circumference of the semiconductor absorption layer 1 has been established as a semiconductor layer (or dielectric layer) of which the refractive index is lower than that of the semiconductor absorption layer 1. With this refractive index difference, the light is entrapped. With this, the very efficient photoelectric conversion can be attained.

Further, when the Schottky junction is formed between the metal and the semiconductor, a depletion layer region of 200 nm or more is formed notwithstanding the zero bias in a situation of the doping concentration being $1\times10^{15}$ to $1\times10^{16}$ cm$^{-3}$. Thus, making the distance between the electrodes small enables a fast and high-sensitivity photodiode operation at a low bias voltage. At this time, it is thinkable that, in the case of having set the thickness of the semiconductor absorption layer to 200 nm or less, the drift time of the photocarrier between the electrodes is several picoseconds also in the semiconductor material (for example, Si) of which a photocarrier mobility is $10^7$ cm/s. And, also in the case of having set the thickness of the semiconductor absorption layer to 1 μm or less, the drift time of 20 ps or less is enabled. Further, when the distance between the MSM electrodes is set to 100 nm or so, the junction electric capacity becomes 10 fF or less in the case of set the MSM junction area to 10 square microns or less. The junction electric capacity becomes 100 fF or less also in the case of set the MSM junction area to 100 square microns or less. That is, when it is assumed that the load resistance is 50 Ω, the circuit time constant is 1 ps with the former, and 10 ps with the latter. Thus, the very fast response is realized.

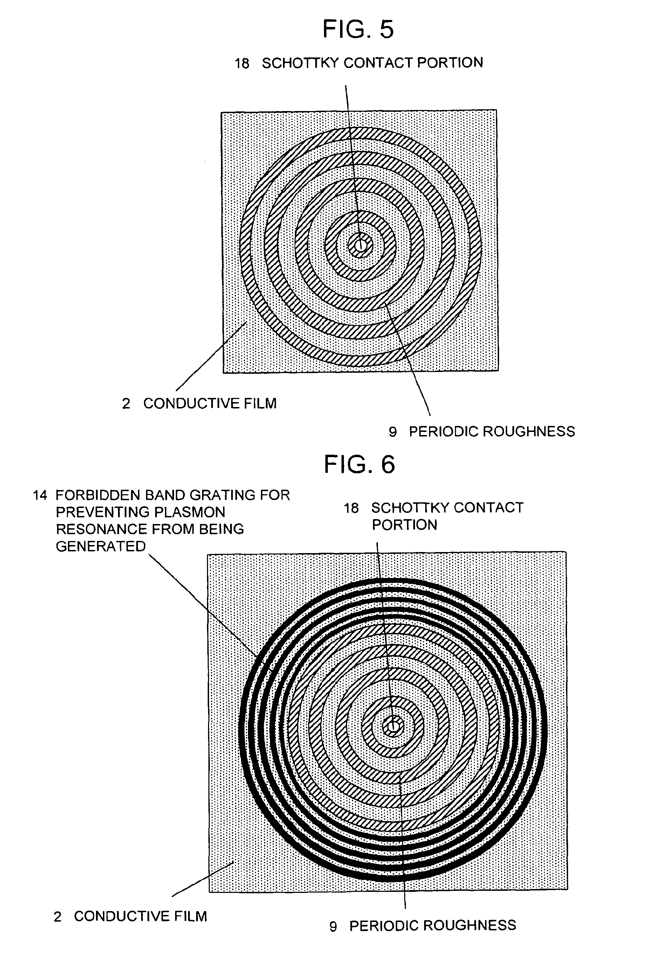

Fig. 5 is an example illustrating a surface plasmon resonance structure that enables the light to be entrapped into size equal to or less than an optical wavelength when the light is incident from the back side of the light absorption layer. That is, the periodic roughness structure 9 is formed around a minute Schottky contact portion 18 existing at the central portion. This makes it possible to couple the incident light to the surface plasmon being induced on the surface of the conductive film (metal film) 2, and to focus the optical energy as the surface plasmon into the Schottky contact portion. In addition hereto, the circumference of the semiconductor light absorption layer 1 being arranged in the Schottky contact portion has been established as a semiconductor layer (or dielectric layer) of which the refractive index is lower than that of the semiconductor absorption layer 1. With this refractive index difference, the light is entrapped. That is, this entrapment effect of the light causes the optical power incident in the semiconductor absorption layer 1 to be localized in the minute Schottky junction region. As a result, the efficient photoelectric conversion is attained in the semiconductor absorption layer having a very small volume.

Fig. 6 is a view illustrating an example of the structure in which a forbidden band grating 14 for preventing the plasmon resonance from being generated has been formed outside the foregoing surface plasmon resonance structure (roughness structure 9). The light incident from the back side of the semiconductor absorption layer 1 is converted into the surface plasmon due to the periodic roughness structure 9 formed in the conductive film 2. However, the converted surface plasmon includes a component being focused into the central part (Schottky contact portion 18) and a component propagating to the outside of the light irradiation area. This component propagating to the outside becomes a loss from a viewpoint of enhancement in the light receiving sensitivity. Thereupon, a structure 14 has been formed in which the periodic roughness structure 9 is made bigger than the light irradiation area, and yet a propagation mode of the surface plasmon is prevented from existing outside the periodic roughness structure 9. With this, the surface plasmon propagating to the outside of the light irradiation area can be bragg-reflected. Thus, it becomes possible to enhance an efficiency of focusing the surface plasmon. Such a forbidden band grating 14 is realized by forming the grating structure of which the period is 1/2 or so of the grating period being obtained from a dispersion relation of the surface plasmon.

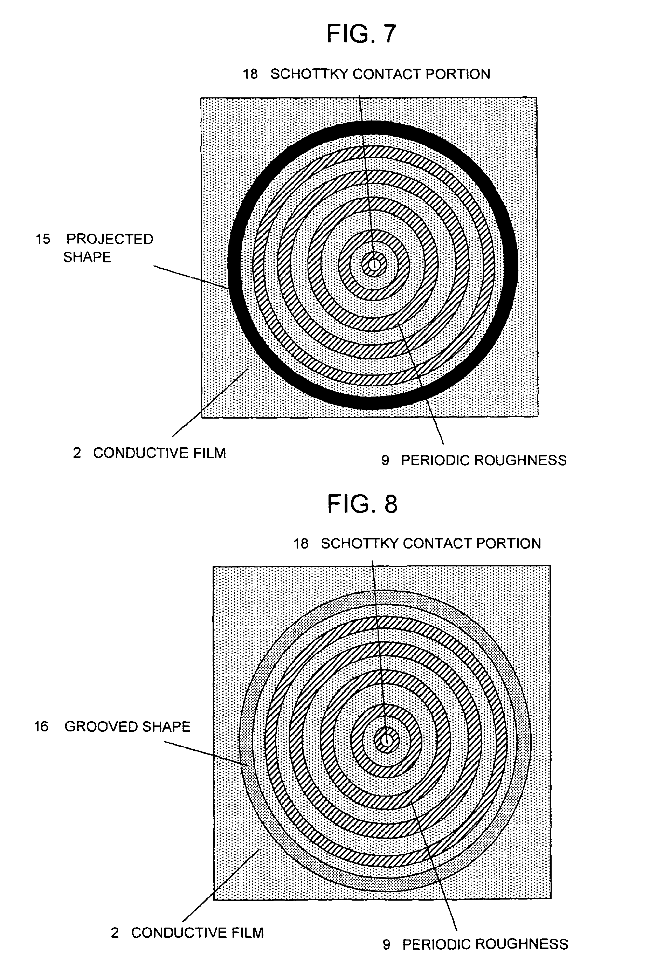

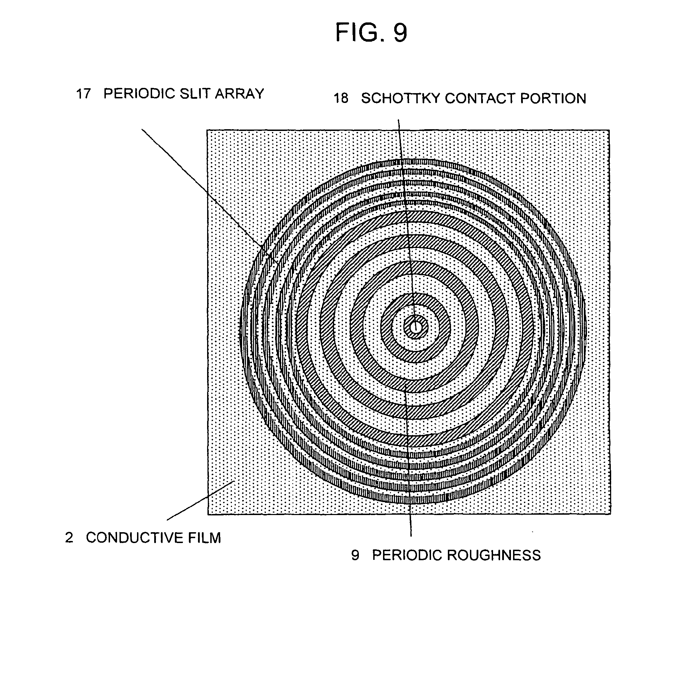

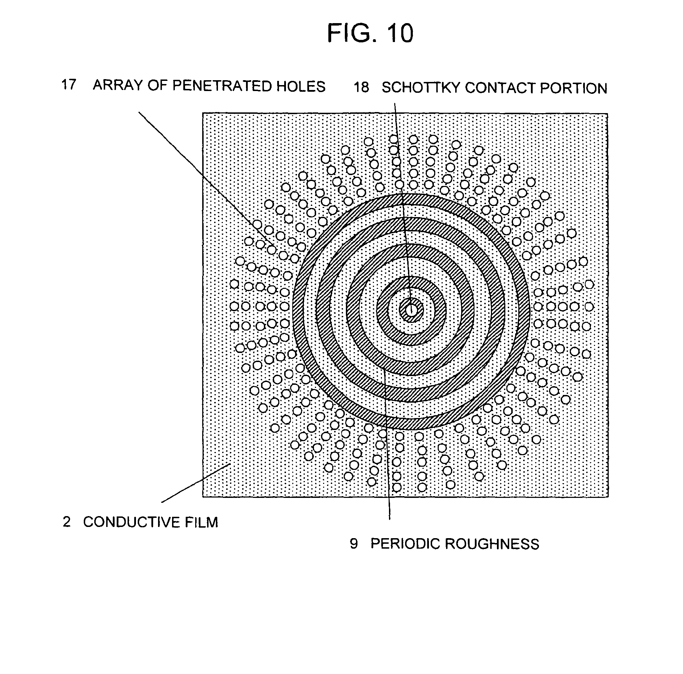

Each of Fig. 7, Fig. 8, Fig. 9 and Fig. 10 is a view illustrating an example of the structure (a projected shape 15, a grooved shape 16, a slit array 17, and a penetrated hole 17) in which the surface plasmon propagating to the outside of the periodic roughness is reflected when the light is made incident from the back side of the semiconductor absorption layer 1, thereby to cause the plasmon resonance for a purpose similar to that of arranging the above-mentioned forbidden band grating 14. That is, the projected shape 15 higher than $\lambda/n_d$ (where $n_d$ is a refractive index of the dielectric layer and $\lambda$ is a wavelength of the light), the grooved shape 16 deeper than $\lambda/n_d$, or the periodic slit 17 obtained by penetrating the conductive film 2 or the array 17 of the minute apertures equal to or less than the wavelength in size has been arranged outside the periodic roughness 9 for causing the surface plasmon resonance. This makes it possible to realize an effect similar to that of the forbidden band grating 14. Further, forming the minute aperture arrays 17 equal to or less than the wavelength in size at a period of 1/2 or so of the plasmon resonance period in a radial manner from the central portion enables the surface plasmon to be effectively reflected.

Additionally, a phase relation with the resonance mode of the surface plasmon being reflected is of importance. For example, by causing the resonance mode and the reflection phase to coincide with each other, the maximum light receiving sensitivity is attained.

The dispersion relation of the surface plasmon is expressed with the following equation 1.

$$[\text{Equation 1}]$$

$$k_{SP} = \omega/c \left\{ (\varepsilon_m \cdot \varepsilon_d) / (\varepsilon_m + \varepsilon_d) \right\}^{1/2}$$

Where $\varepsilon_m$ and $\varepsilon_d$ are a permittivity of the metal for generating the surface plasmon, and the dielectric substance neighboring it, respectively.

In addition hereto, a propagation length of the surface plasmon is expressed with the following equation 2.

$$[\text{Equation 2}]$$

$$L_{SPP} = c/\omega \left\{ (\varepsilon_m' + \varepsilon_d) / \varepsilon_m' \right\}^{3/2} \cdot \varepsilon_m'^2 / \varepsilon_m''$$

Where a complex permittivity $\varepsilon_m$ of the metal is expressed as $\varepsilon_m' + i\varepsilon_m''$.

That is, the optical loss of the surface plasmon largely depends upon a ratio of the square of an imaginary part to an actual part of a permittivity of the metal film. Thus, the conductive layer of the present invention is desirably comprised of at least one metal selected from a group consisting of Al, Ag, Au, and Cu (or, an alloy selected from them). Further, it is very important from a viewpoint of a reduction in a propagation loss of the surface plasmon to make the random roughness of the metal surface small. Thus, the underlayer such as Ta, Cr, Ti, and Zr is desirably formed. Or, the alloying of the metal film by adding the element such as Nb by a very small amount is also effectual.

An intensity distribution of the proximity field light due to the surface plasmon is influenced and changed by the periodic roughness structure, the refractive index of the neighboring dielectric layer, an arrangement of the MSM electrodes, and the refractive index or an absorption coefficient of the semiconductor absorption layer.

And, adopting the structure of the present invention that causes the optical energy to be localized in a very tiny region of the semiconductor makes it possible to generate the electron · positive hole pairs (photocarriers). Thus, causing the depletion region being formed in the semiconductor absorption layer due to the Schottky junction, and the region in which the photocarrier is generated due to the proximity field to coincide with each other enables the efficient photocarrier formation and the localized movement of the photocarrier to be realized. As a result, the photodiode having a high quantum efficiency and a fast response characteristic is obtained.

In the case of utilizing the p-i-n junction structure, the photocarrier can be efficiently generated also in a minute region of 1 $\mu$m owing to the focusing of the surface plasmon caused by the periodic roughness formed in the junction circumference, and the light entrapment effect utilizing a difference of the refractive index with the dielectric layer neighboring the semiconductor absorption layer.

At this time, the Schottky junction region or the p-in junction region for generating and sweeping the photocarrier can be formed so that its size is 10 square microns or less. As a result, the electric capacity in the junction can be lowered to a very small level. Thus, the circuit time constant in the case of performing a high-frequency operation for the photodiode can be lowered to several picoseconds or less, which realizes a high-frequency operation of several tens of Giga Hertz or more.

An optical waveguide of which a difference of the refractive index between a core and a clad is 5% or more can be utilized in order to entrap the light into a region equal to or less than a wavelength (or 10 square microns or less) in size. Such a channel-type optical waveguide has a structure in which the circumference of the core is surrounded by the medium of which the refractive index is smaller than that of the core. And, a difference of the refractive index between the core and the clad layer causes the light to propagate while repeating total internal reflection. In this case, the larger a difference of the refractive index between the core and the clad layer, the more strongly the light is entrapped into the core. Thus, even though the waveguide is abruptly bent at a small curvature, the light is wave-guided along it. And, with the case that a difference of the refractive index is 5% or more, a light spot diameter of 10 $\mu$m or less can be realized. In addition hereto, with the case that a difference of the refractive index between the core and the clad is approximately 10% to 40%, a light spot diameter equal to or less than a wavelength can be realized.

With the structure in which a waveguide core of which the sectional size is approximately 0.3 $\mu$m X 0.3 $\mu$m is made of Si (the refractive index is approximately 3.4), and the circumference (clad layer) of this waveguide core is shrouded in SiO$_2$ (the refractive index is approximately 1.5), a mode size of the light is reduced to a size almost identical to that of the waveguide core. The wave-guiding loss due to the light absorption occurs in the Si waveguide with the case that the wavelength of the light being wave-guided is 850 nm or so. Thereupon, employing, as a waveguide core, SiON etc. exhibiting an optical transmission property that the loss can be ignored over a wide range of wavelengths, and shrouding the circumference thereof in the clad comprised of $SiO_2$ yields the refractive index difference of 5% or more. In this case, the light spot diameter becomes approximately 1 to 4 $\mu$m because entrapment of the light becomes weaker as compared with the case of the semiconductor core (Si).

In the case of leaping up an optical path of the optical signal light coming from the optical waveguide having a strong light entrapment property in a vertical direction by utilizing a 45° mirror (or diffraction grating), and optically coupling the optical signal light in the above-mentioned photodiode structure, the optical coupling in a very tiny region is enabled. As a result, a compatibility of the high sensitivity and the high speediness is realized.

The wavelength region of the light in which the present invention is available extends over a wide wavelength range including visible light, near infrared-ray light, and infrared-ray light. A fast photodetector for efficiently generating the photocarrier and gaining the electric signal in the region equal to or smaller than the wavelength is obtained owing to the metal periodic structure for inducing the surface plasmon resonance, the structure in which the semiconductor absorption layers for efficiently entrapping and transmitting the light have been laminated, and besides them, the regulation of the refractive index of the dielectric layer neighboring the semiconductor absorption layer.

Hereinafter, specific examples will be explained while a reference to the accompanied drawings is made.

[EXAMPLE 1]

Fig. 1 is a cross sectional view of the Si Schottky type photodiode illustrating a first embodiment of the present invention.

The Si Schottky type photodiode of the present invention has a metal-semiconductor Schottky junction formed on one part of a semiconductor absorption layer 1 of which the surface has been insulated, for example, SOI (Silicon-on-Insulator). Conductive films 2 for causing the surface plasmon are lamination-formed around this Schottky junction. A periodic roughness structure (periodic roughness structure in which the light incident from the back side (support substrate 8 side) of the semiconductor absorption layer 1 causes the surface plasmon resonance) 9 is made around the Schottky junction and yet in the lower side of the lamination-formed conductive film 2. Additionally, in Fig. 1, 3 is a lower electrode layer of the semiconductor absorption layer 1, and 4 is a buried oxide layer formed on the support substrate 8. 5 is a load resistance, and 6 is a bias power source. 7 is an oxide film formed on the buried oxide layer 4, and the conductive film 2 is formed on the oxide film 7.

The conductive film 2 formed for inducing the surface plasmon is configured of the metals such as Al, Ag, Au and Cu (or the alloy having at least one member of the foregoing metals as an essential component element). So as to form the Schottky junction, a substrate film comprised of the metals such as Cr, Ta, and Ni may be formed.

An n+ Si layer of which a concentration of a dopant such as P is $1 \times 10^{20}$ cm$^{-3}$ or more can be used as a substrate in the lower electrode layer 3. In this case, it is necessary to epitaxial-grow an n- Si layer, being the semiconductor absorption layer (light absorption layer) 1, on an n+ Si layer. However, the dopant concentration of the light absorption layer becomes high due to a thermal diffusion of the dopant element when a growth temperature is raised to 800 °C or more. And, the depleting voltage is augmented, and the thickness of the depletion layer that is obtained at the time of forming the Schottky junction becomes thin. That is, fast driving at a low voltage becomes difficult to attain. Thus, forming the thin n- Si layer (semiconductor absorption layer (light absorption layer) 1 on the n+ Si layer necessitate a technology of the epitaxial growth at a low temperature equal to or less than 600 °C.

In this example, so as to make the light incident from back side of the substrate 8, the Si semiconductor support substrate 8 was layer-thinned to approximately 50 to 100 $\mu$m with CMP (chemical mechanical polishing) or the like. In addition hereto, the support substrate 8 in the back side of the photodiode was dissolved, and removed with a mixture solution of a hydrofluoric acid and nitric acid so as to form a window for making the light incident, of which a diameter was approximately 10 to 50 $\mu$m.

The light incident from the back side of the support substrate 8 is converted into the surface plasmon due to the periodic roughness structure 9 for causing the surface plasmon resonance, and focused into the Schottky junction existing in the central portion. Further, the circumference of the semiconductor absorption layer 1 is configured of the semiconductor layer (or the dielectric layer (oxide film 7)) of which the refractive index is lower than that of the semiconductor absorption layer 1. Thus, the light power incident on the semiconductor absorption layer 1 is localized in the minute Schottky junction region owing to the entrapment effect caused by the refractive index difference. Thus, the efficient photoelectric conversion is attained in the semiconductor absorption layer having a very small volume.

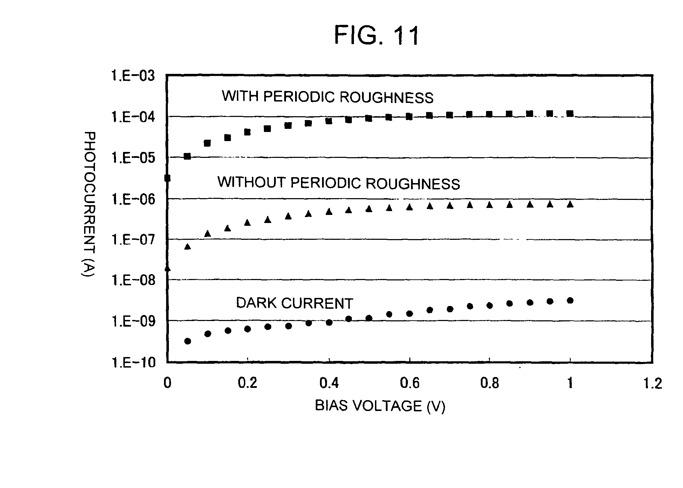

Fig. 11 is a graph illustrating the special features of the photodiode in the case that the circumference of the Schottky junction has been irradiated with the light. That is, Fig. 11 is a view for illustrating a comparison of the sensitivity feature between the case of having formed the periodic structure for causing the plasmon resonance (for example, the roughness structure having the period of 560 nm and the height of 50 nm obtained by performing an electromagnetic field computation with a finite difference time/region method), in the photodiode in which an AG electrode having a thickness of 120 nm has been arranged and formed on the surface of the Si semiconductor having a diameter of 200 nm, and the case of having no foregoing periodic roughness structure. In the experiment, a photocurrent was observed by making laser light (wavelength: 850 nm, power: 1 mW) incident vertically from the back side of the substrate 8. It can be seen from Fig. 11 that forming the periodic roughness structure 9 for causing the plasmon resonance yields the photocurrent larger by two digits or more. Additionally, the quantization efficient at this time was approximately 50%.

Next, the manufacturing method will be explained by exemplifying the case of the Si semiconductor.

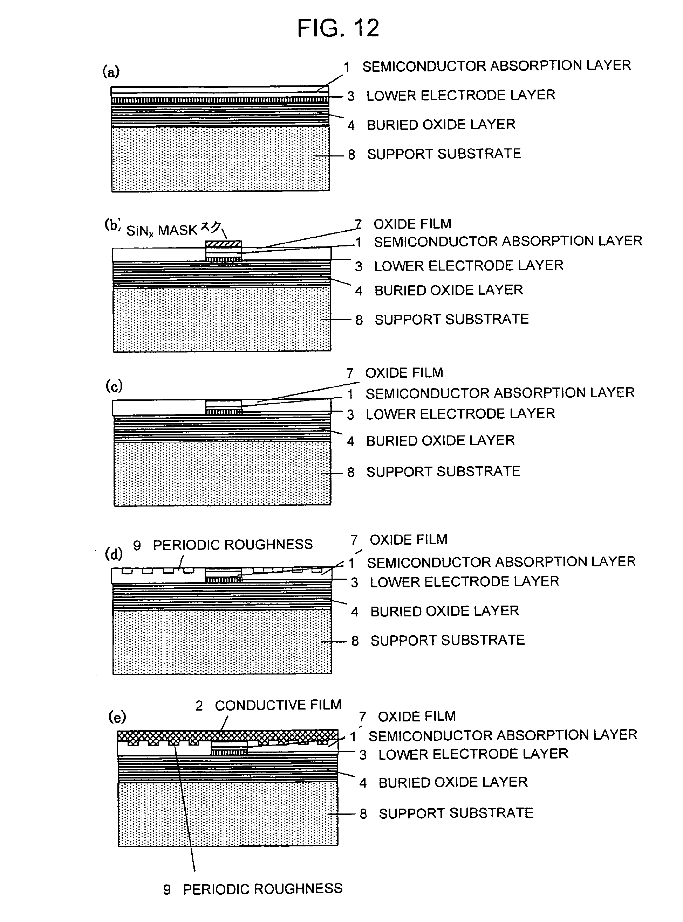

Fig. 12 is a cross sectional view illustrating the manufacturing method of the photodiode of this example.

At first, as shown in Fig. 12 (a), an n-doped SOI substrate is employed. The semiconductor absorption layer 1 having a thickness of 200 nm or so was epitaxial-grown thereon. A resistivity of the semiconductor absorption layer 1 at this time is 1 to 10 $\Omega \cdot$cm or so, and the doping concentration is approximately $1 \times 10^{15}$ to $1 \times 10^{16}$ $cm^{-3}$ .

Next, as shown in Fig. 12 (b), the n-type semiconductor absorption layer 1 was patterned, and the junction size was specified. That is, it was patterned with a reactive etching by employing a silicon nitride $SiN_x$ film as a mask. A mixture gas of $C_4F_8$ gas and $SF_6$ was employed as reactive gas. And, the heat treatment in vapor was performed at 1000 °C and for approximately 140 minutes. With this, a mesa structure, being a foundation for manufacturing the Schottky junction, was formed.

Thereafter, as shown in Fig. 12 (c), the $SiN_x$ film was put in hot phosphoric acid of which the temperature was approximately 130 °C for approximately one hour so that it was removed. At this time, by optimizing the mesa form and the hot oxidation process, a relatively flat surface is attained. In addition hereto, performing the CMP process yields the flatness of several nanometers or so.

By the way, the metal layer (conductive film) for forming the Schottky junction is film-formed on the surface of the mesa shape. At this time, as shown in Fig. 12 (d), the periodic grooved pattern (roughness pattern 9) was formed on the surface of the Si oxide film 7 around the semiconductor mesa structure with the reactive etching.

And, as shown in Fig. 12 (e), the metal selected from a group consisting of Al, Ag, Au, and Cu (or, the alloy having the foregoing metal element as a component element) was deposited, and the conductive film 2 was formed for a purpose of causing the surface plasmon, and yet of playing a role as a metal electrode.

[EXAMPLE 2]

Fig. 2 is a cross sectional view of the Ge Schottky type photodiode illustrating a second embodiment of the present invention.

The Schottky type photodiode of the present invention has a metal-semiconductor Schottky junction formed on one part of the semiconductor absorption layer 1 of which the surface has been insulated, for example, SOI (Silicon-on-Insulator). An appropriate buffer layer such as $Si_{0.5}Ge_{0.5}$, of which the thickness was approximately 10 nm was formed on the SOI layer having a thickness of 100 nm or less with a gas source MBE method because the Ge layer was not lattice-matched to the Si layer. An $n^-$ Ge layer was grown on the buffer layer, thereby to form a high-quality Ge semiconductor absorption layer 1 having a low density of penetration transition. Additionally, the Ni substrate layers have been laminated with an evaporation method or the like so as to form the Schottky junction. In Fig. 2, 2 is a conductive film, and 3 is a lower electrode layer of the semiconductor absorption layer 1. 5 is a load resistance, and 6 is a bias power source. 7 is an oxide film formed on a support substrate 8, and the conductive film 2 is formed on the oxide film 7.

The conductive films 2 for causing the surface Plasmon are lamination-formed around the Schottky junction. And yet, the periodic roughness structure 9 in which the light incident from the back side (support substrate 8 side) of the semiconductor absorption layer 1 causes the surface plasmon is made.

The conductive film 2 formed for inducing the surface plasmon is configured of the metals such as Al, Ag, Au and Cu (or the alloy having at least one member of the foregoing metals as an essential component element). Additionally, the substrate layer formed for forming the Schottky junction may be configured of Cr and Ta. The lower electrode layer 3, which is a layer configured by performing a P (phosphoric)-doping process for the SOI layer, being a substrate of a Ge growth layer, has a sufficient conductivity.

In this example, so as to make the light incident from the back side of the support substrate 8, the Si semiconductor support substrate 8, similarly to the case of the first example 1, is layer-thinned to approximately 50 to 100 $\mu$m with the CMP or the like in the case of making the light having a wavelength of 1 $\mu$m or less, which was influenced by the light absorption of Si, incident. And, the support substrate 8 in the back side of the photodiode was dissolved, and removed by employing a mixture solution of a hydrofluoric acid and nitric acid so as to form a window for making the light incident, of which the diameter was approximately 10 to 50 $\mu$m.

The light incident from the back side of the support substrate 8 is converted into the surface plasmon due to the periodic roughness structure 9 for causing the surface plasmon resonance, and focused into the Schottky junction existing at the central portion. Further, the circumference of the semiconductor absorption layer 1 is configured of the semiconductor layer (or the dielectric layer (oxide film 7)) of which the refractive index is lower than that of the semiconductor absorption layer 1. Thus, the light power incident on the semiconductor absorption layer 1 is localized in the minute Schottky junction region owing to the entrapment effect caused by a difference of the refractive index. With this, the efficient photoelectric conversion is attained in the semiconductor absorption layer having a very small volume.

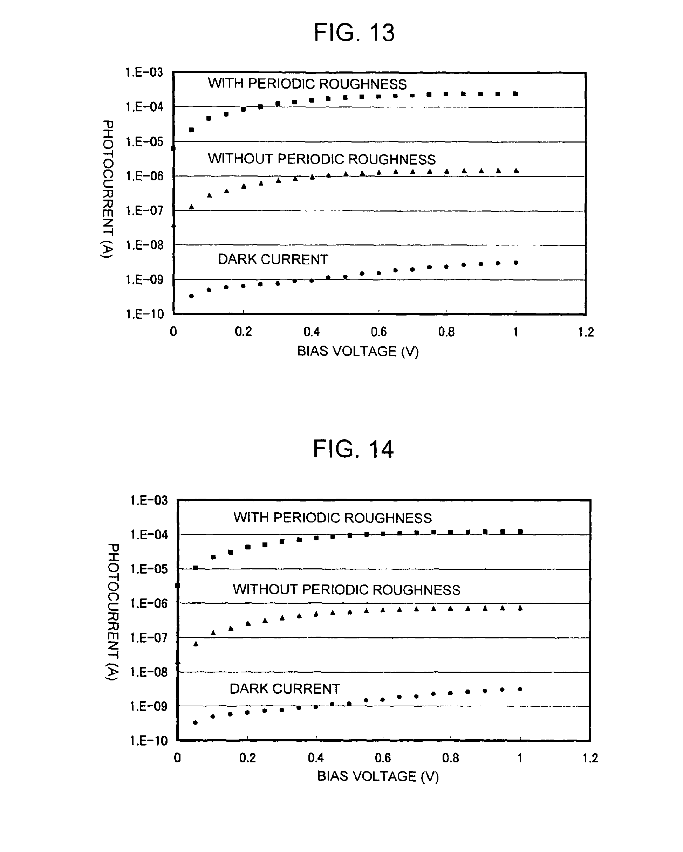

Fig. 13 is a graph illustrating the special features of the photodiode in the case that the circumference of the Schottky junction has been irradiated with the light. That is, Fig. 13 is a view illustrating a comparison of the sensitivity feature between the case of having formed the periodic structure for causing the plasmon resonance (for example, the roughness structure having the period of 560 nm and the height of 50 nm obtained by performing an electromagnetic field computation with a finite difference time/region method), in the photodiode in which an Ag electrode having a thickness of 120 nm has been arranged and formed on the surface of the Ce semiconductor having a diameter of 200 nm, and the case of having no foregoing periodic roughness structure. In the experiment, a photocurrent was observed by making laser light (wavelength: 850 nm, power: 1 mW) incident vertically from the back side of the substrate 8. It can be seen from Fig. 13 that forming the periodic roughness structure 9 for causing the plasmon resonance yields the photocurrent larger by two digits or more. Additionally, the quantization efficient at this time was approximately 80%.

It is possible in an optical communication wavelength band of which the wavelength is 1.3 to 1.6 $\mu$m to handle the Si support substrate 8 as a transparent substrate. Thus, only converting the substrate backside into a mirror surface without performing a working process such as a process of removing the support substrate yields the quantization efficiency of approximately 60%, and the sufficient light receiving sensitivity is attained.

[EXAMPLE 3]

Fig. 3 is a cross sectional view of a p-i-n type photodiode illustrating a third embodiment of the present invention.

The p-i-n type photodiode of the present invention has a structure in which the p-i-n type junction has been lamination-formed on one part of a semiconductor absorption layer 1 of which the surface has been insulated, for example, the SOI (Silicon-on-Insulator) with CVD (Chemical Vapor Deposition) or the like. A conductive film 2 for causing the surface plasmon is lamination-formed around the p-i-n junction. And yet, the periodic roughness structure (the periodic roughness structure in which the light incident from the back side (support substrate 8 side) of semiconductor absorption layer 1 causes the surface Plasmon resonance) 9 is made. Additionally, in Fig. 3, 4 is a buried oxide layer formed on a support substrate 8, 5 is a load resistance, and 6 is a bias power source. 7 is an oxide film formed on the buried oxide layer 4, and the conductive film 2 is formed on the oxide film 7.

The conductive film 2 for causing to the surface plasmon is lamination-formed on a p$^+$ electrode layer 11 on the semiconductor absorption layer 1. Thus, the conductive film 2 and the p$^+$ electrode layer 11 are electrically connected to each other. Further, the conductive film 2 formed for inducing the surface Plasmon is configured of the metals such as Al, Ag, Au and Cu (or the alloy having at least one member of the foregoing metals as an essential component element).

Fig. 14 is a graph illustrating the special features of the photodiode in the case that the circumference of the pin junction has been irradiated with the light. That is, Fig. 14 is a view illustrating a comparison of the sensitivity feature between the case of having formed the periodic structure for causing the plasmon resonance (for example, the roughness structure having the period of 560 nm and the height of 50 nm obtained by performing an electromagnetic field computation with a finite difference time/region method), in the photodiode in which an Ag electrode having a thickness of 120 nm has been arranged and formed on the surface of the Si semiconductor having a diameter of 200 nm, and the case of having no foregoing periodic roughness structure. In the experiment, a photocurrent was observed by making the laser light (wavelength: 850 nm, power: 1 mW) incident vertically from the back side of the substrate 8. It can be seen from Fig. 14 that forming the periodic roughness structure 9, which causes the plasmon resonance, yields the photocurrent larger by two digits or more. Additionally, the quantization efficient at this time was approximately 40%.

[EXAMPLE 4]

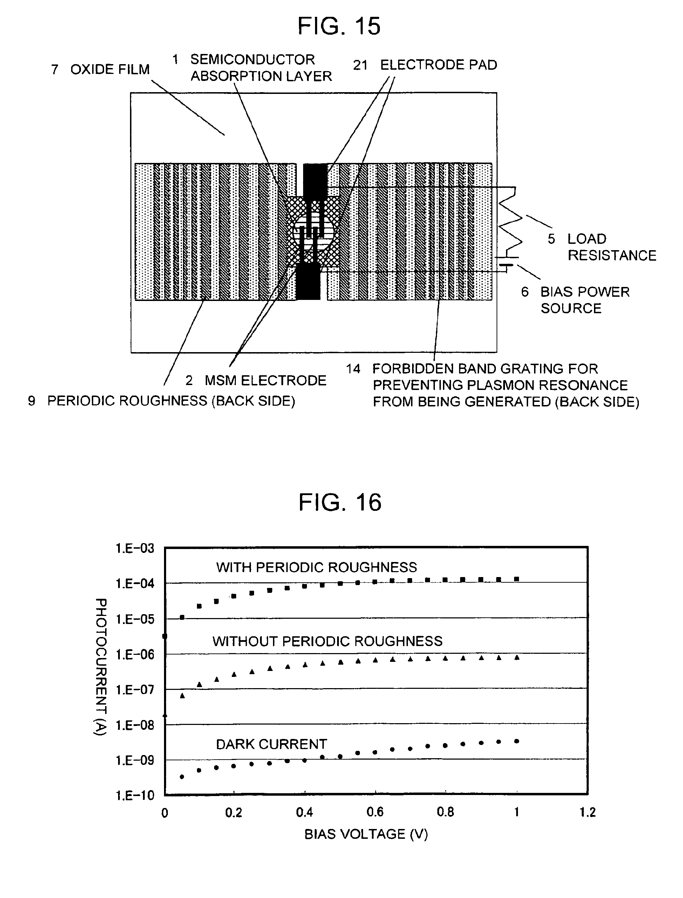

Fig. 4 and Fig. 15 are a cross sectional view and a plan of an MSM type photodiode illustrating a fourth embodiment of the present invention, respectively.

The MSM type photodiode of the present invention has a structure in which the metal-semiconductor-metal (MSM) junction has been formed on one part of the semiconductor absorption layer 1 of which the surface has been insulated, for example, the SOI (Silicon-on-Insulator). And, a gap between the metal electrodes is defined to be a distance smaller than $\lambda$/n ($\lambda$: a wavelength of the incident light, and n: an optical refractive index of the semiconductor layer). This yields a structure in which the light incident from the back side of the semiconductor absorption layer 1 is entrapped into the semiconductor absorption layer 1. Additionally, in Fig. 4 and Fig. 15, 4 is a buried oxide layer formed on a support substrate 8, 5 is a load resistance, and 6 is a bias power source. 7 is an oxide film formed on the buried oxide layer 4, and a conductive film 2 is formed on the oxide film 7. 14 is a forbidden band grating for preventing the plasmon resonance from being generated. The forbidden band grating 14 is formed outside the periodic roughness structure 9. 21 is an electrode pad.

An MSM electrode 13 is configured of the metals such as Al, Ag, Au and Cu (or the alloy having at least one member of the foregoing metals as an essential component element) so as to induce the surface plasmon. Additionally, so as to form the Schottky junction, a substrate film comprised of the metals such as Cr, Ta, and Ni may be formed. Further, it is also possible to form an Ohmic junction by using Ti etc. as an electrode film facing the MSM electrode that is employed for a substrate film.

The conductive film 2, which can causes the surface plasmon, is formed adjacently to the circumference of the MSM junction. And, the periodic roughness structure 9 is made so as to causes the surface plasmon resonance.

Fig. 16 is a graph illustrating the special features of the MSM type photodiode. That is, Fig. 16 is a view illustrating a comparison of the sensitivity feature between the case of having formed the periodic structure for causing the plasmon resonance (for example, the roughness structure having the period of 560 nm and the height of 50 nm obtained by performing an electromagnetic field computation with a finite difference time/region method), in the photodiode in which an Ag electrode having a thickness of 120 nm has been arranged and formed on the surface of the Si semiconductor having a diameter of 200 nm, and the case of having no foregoing periodic roughness structure. In the experiment, a photocurrent was observed by making the laser light (wavelength: 850 nm, power: 1 mW) incident vertically from the back side of the substrate 8. It can be seen from Fig. 16 that forming the periodic roughness structure 9 for causing the plasmon resonance yields the photocurrent larger by two digits or more. Additionally, the quantum efficiency at this time was approximately 50%.

[EXAMPLE 5 to EXAMPLE 8]

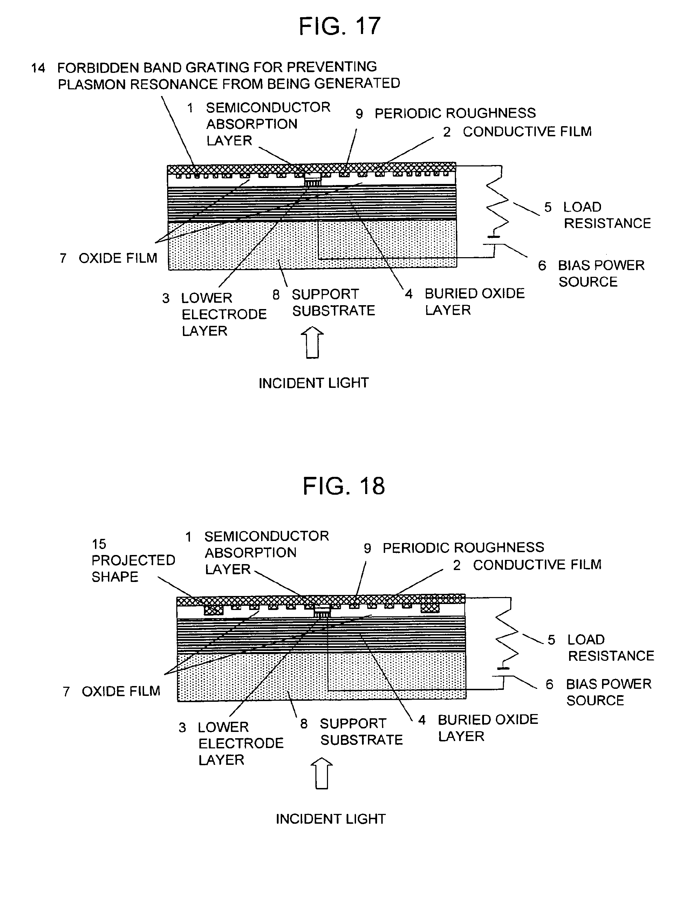

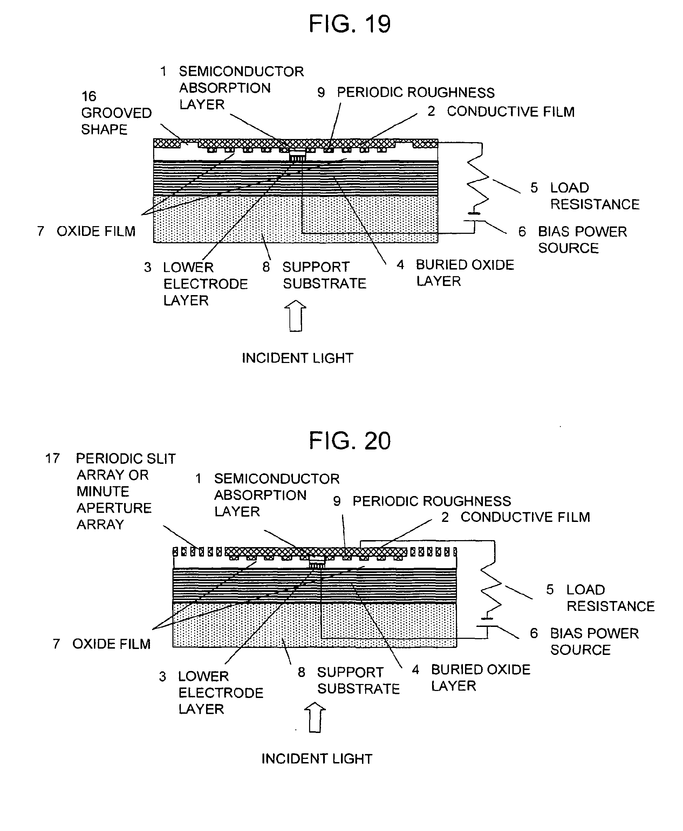

Fig. 17, Fig. 18, Fig. 19 and Fig. 20 show cross sectional views of the Schottky type diodes in which a forbidden band grating 14 having a function for reflecting the surface plasmon, a projected shape 15, a grooved shape 16, and a periodic slit array or a minute aperture array 17 have been formed outside the periodic roughness structures 9 of the above-mentioned example 1 (Fig. 1), example 2 (Fig. 2), example 3 (Fig. 3), and example 4 (Fig. 4), which causes the surface plasmon resonance, respectively.

The quantum efficiency in this case is shown in Table-1.

Table-1

| Surface plasmon resonance structure | Quantum efficiency (%) |
|---|---|
| Only periodic roughness | 32 |
| Periodic roughness + forbidden band grating | 75 |
| Periodic roughness + projected shape | 80 |
| Periodic roughness + grooved shape | 45 |
| Periodic roughness + periodic slit array | 89 |
| Periodic roughness + minute aperture array | 78 |

The quantum efficiency that is two times to three times or so as large as that of the case of only the periodic roughness structure 9 is gained in any structure. And, it can be seen from it that the surface plasmon is efficiently reflected, which realizes the focusing into the Schottky junction, and furthermore the localization of the light energy into the semiconductor absorption layer.

[EXAMPLE 9]

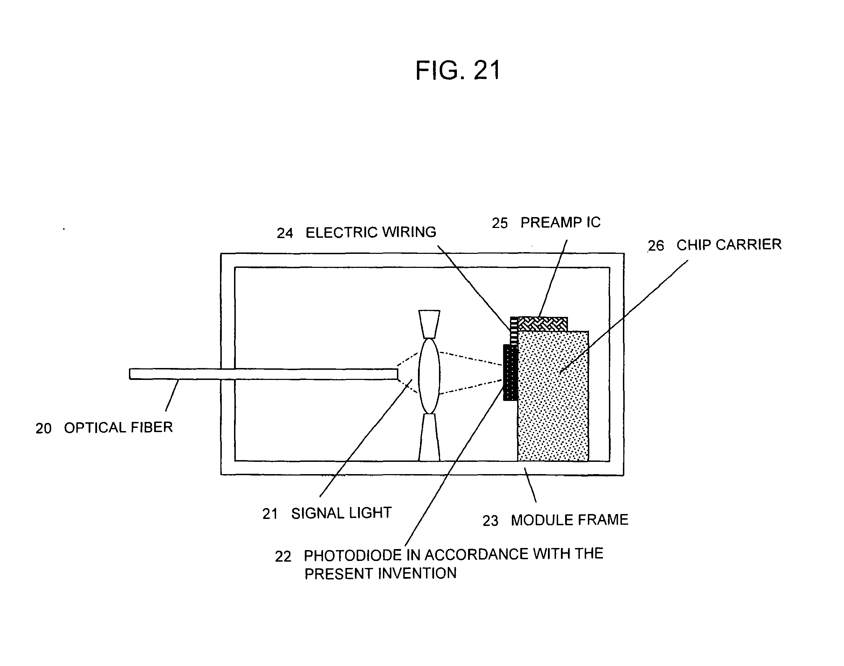

Fig. 21 is a schematic view illustrating an optical reception module for 40 G bps transmission having a Schottky type photodiode 22 of the present invention installed therein.

In this example, the photodiode is a Schottky type photodiode that uses the substrate obtained by epitaxial-growing the Ge film on the SOI substrate, and has a Ni/Au electrode formed thereon. It is a photodiode having the conductive film having the roughness structure (the roughness structure comprised of Ag (or Au), which enables the light coupling and the focusing owing to the surface plasmon), formed around this photodiode. And, with the case of employing the conductive film (metal film) for transmission by the near infrared-ray light having a wavelength of 1.55 $\mu$m, the roughness period of the roughness structure thereof becomes approximately 1.2 $\mu$m, and with the case of employing the conductive film having the eight-period roughness existing on a concentric circle, the diameter of its periphery becomes approximately 20 $\mu$m. The depth of the roughness at this time was set to 0.1 to 0.4 $\mu$m or so. The diameter of the Schottky junction was set to 0.3 to 0.7 $\mu$m or so. The photodiode is installed in a chip carrier 26. And, it is optically coupled by an optical fiber 20 and a lens, and further is electrically connected to a rear-stage preamp IC 25.

Commonly, in the optical reception module of 40 G bps, a side incidence waveguide type photodiode is, in many cases, employed for the photodiode being installed therein. The reason is that, when the absorption layer is made thin so as to reduce an electric charge carrier moving time, the high quantization efficient cannot be attained in a surface incidence type photodiode in which the light is made incident on the surface of the semiconductor. On the other hand, the waveguide type photodiode absorbs the light in an intra-plane direction of the absorption layer, thereby allowing the high quantization efficient to be attained with the electric charge carrier moving time kept short. However, the thickness of the semiconductor absorption layer, commonly, is 1 μm or less in a waveguide type element for 40 G bps. A coupling tolerance of a position with the optical fiber in this case needs to be kept at a level of ± 1 μm or so, which poses a big problem with both of a package design and a manufacturing cost.

On the other hand, the photodiode in accordance with the present invention has a an active effective-diameter of 20 μm. For this, the coupling tolerance can be enlarged to ± 2 μm or more. As a result, the light coupling can be carried out only with simple lens coupling. With this, a low manufacturing cost of the reception module for optical transmission is enabled.

Incidentally, in the optical reception module of 40 G bps in accordance with the present invention shown in Fig. 21, the minimum reception sensitivity of -12 dBm was attained in 1.55 μm wavelength transmission. Thus, it was confirmed that reception module having a level that was also characteristically equal to that of the optical reception module of 40 G bps having the general waveguide type photodiode installed therein was realized.

[EXAMPLE 10]

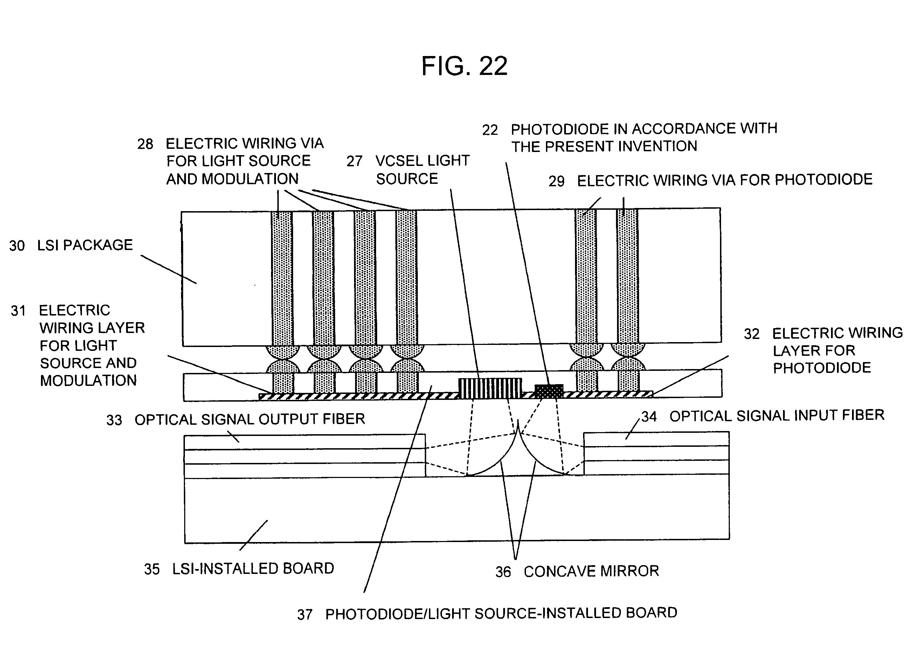

Fig. 22 is a view illustrating a configuration of the LSI inter-chip optical interconnect having the photodiode of the present invention installed therein.

In Fig. 22, the optical signal coming from an optical signal input fiber 34 is radiated into a photodiode 22 in accordance with the present invention by a concave mirror 36. With the case of employing the light of which the wavelength is 850 nm, the semiconductor material of the photodiode is Si, and the roughness period of the metal period structure is 600 to 700 nm. The photodiode made of Si generates an optical current by optically coupling the proximity field light being produced by the metal period structure body to the semiconductor absorption layer besides it. This allows the current corresponding to the optical signal to flow to LSI through a photodiode wiring layer 32. Further, forming the metal period structure for triggering the surface plasmon resonance makes it possible to enlarge a coupling tolerance of the position between the concave mirror and the photodiode to ± 1 μm or more.

A photodiode wiring layer 32 is electrically connected to the photodiode wiring via 29 of the LSI. Herein, the other well-known methods in which a planar optical waveguide is used instead of the optical fiber can be employed for inputting the optical signal. Further, a focusing mechanism such as a convex lens can be employed instead of the concave mirror. Further, the preamp for amplifying the electric signal can be placed in the way to the photodiode wiring layer immediately after the photodiode.

The electric signal coming from the LSI, which goes through an electric wiring layer 31 for a light source and a modulation from an electric signal via 28 for a light source and a modulation, is converted into the optical signal by a VCSEL (Vertical-Cavity Surface-emitting Laser) optical source 27 provided with an electric modulation mechanism. The optical signal is reflected at the concave mirror 36, and sent to an optical signal output fiber 33. The VCSEL optical source 27 provided with the electric modulation mechanism can be replaced with the other well-known mechanisms for modulating the light by electricity, for example, a Mach-Zehnder type modulator for modulating the light coming from an external light source with an electro-optical effect or a thermo-optical effect.

Herein, in the general LSI intra-chip interconnect, in the case of aiming at a fast operation of 20 GHz or more, the compound semiconductor material such as InGaAs grown on the InP substrate is employed for the photodiode being installed therein so as to make the response fast. However, the compound semiconductor has poor matching to the Si semiconductor element in terms of the manufacturing process, and hence becomes costly.

On the other hand, the manufacturing cost of the photodiode of the present invention can be reduced because Si can be employed therefor. And, the fast photoelectric conversion operation of approximately 40 GHz was confirmed in the optical interconnect in accordance with the present invention shown in Fig. 22.

This application is based upon and claims the benefit of priority from Japanese patent application No. 2006-342336, filed on December 20, 2006, the disclosure of which is incorporated herein in its entirety by reference.

**Claims**

1. A Schottky barrier type photodiode having a conductive layer formed on a surface of a semiconductor layer, said photodiode configured so that light can be incident on a back side of said semiconductor layer, wherein a periodic structure in which the light incident from the back side of said semiconductor layer causes a surface plasmon resonance is made around a Schottky junction of said photodiode.

**2.** A p-i-n type photodiode having a p-i-n type junction formed on a surface of a semiconductor layer, said photodiode configured so that light can be incident on a back side of said semiconductor layer, wherein a conductive layer is formed, and a periodic structure in which the light incident from the back side of said semiconductor layer causes a surface plasmon resonance is made around the p-i-n junction of said photodiode.

**3.** A photodiode having metal-semiconductor-metal junctions intervally arranged on a surface of a semiconductor layer, said photodiode configured so that light can be incident on a back side of said semiconductor layer, wherein a conductive layer is formed, and a periodic structure in which the light incident from the back side of said semiconductor layer causes a surface plasmon resonance is made around the metal-semiconductor-metal junction of said photodiode.

**4.** The photodiode as claimed in Claim 3;
wherein an interval of the metal-semiconductor-metal junctions arranged on the surface of the semiconductor layer is equal to or less than $\lambda/n$ (where $\lambda$: a wavelength of the light incident from the back side of the semiconductor layer, and n: a refractive index of the light in the semiconductor layer); and
wherein said metal layer is a layer in which a metal layer forming a Schottky junction with said semiconductor, and a layer comprised of a conductive material capable of inducing a surface plasmon have been laminated, or a metal layer capable of forming the Schottky junction with said semiconductor, and yet of inducing the surface plasmon.

**5.** The photodiode as claimed in Claim 3 or Claim 4,
wherein, with respect to the metal-semiconductor-metal junction, at least one of metal-semiconductor junctions facing each other is a Schottky barrier junction.

**6.** The photodiode as claimed in one of Claim 1 to Claim 5,
wherein the periodic structure for causing the surface plasmon resonance is a structure in which the conductive layers capable of inducing the surface plasmon have been laminated on the surface of the semiconductor layer having roughness formed thereon.

**7.** The photodiode as claimed in one of Claim 1 to Claim 6,
wherein the periodic structure for causing the surface plasmon resonance is a structure in which the conductive layers capable of inducing the surface plasmon have been laminated on the surface of a dielectric layer having roughness formed thereon.

**8.** The photodiode as claimed in one of Claim 1 to Claim 7,
wherein the periodic structure for preventing the surface plasmon resonance from being generated is made outside the periodic structure for causing the surface plasmon resonance.

**9.** The photodiode as claimed in one of Claim 1 to Claim 8,
wherein a stepped structure for reflecting the surface plasmon is made outside the periodic structure for causing the surface plasmon resonance.

**10.** The photodiode as claimed in Claim 9, wherein the stepped structure is comprised of a projected shape higher than $\lambda/n_d$ (where $n_d$ is a refractive index of the light in the semiconductor layer or the dielectric layer neighboring a conductive film and $\lambda$ is a wavelength of the light).

**11.** The photodiode as claimed in Claim 9 or Claim 10,
wherein the stepped structure is comprised of a grooved shape deeper than $\lambda/n_d$ (where $n_d$ is a refractive index of the light in the semiconductor layer or the dielectric layer neighboring the conductive film and $\lambda$ is a wavelength of the light).

**12.** The photodiode as claimed in one of Claim 9 to Claim 11, wherein the stepped structure is comprised of a shape formed in the conductive material, said shape having bores of which a diameter is equal to or smaller than the wavelength of the incident light arrayed thereon.

**13.** The photodiode as claimed in one of Claim 9 to Claim 12, wherein the stepped structure is comprised of a shape formed in the conductive material, said shape having slits of which a width is equal to or smaller than the wavelength of the incident light arrayed thereon.

14. The photodiode as claimed in one of Claim 9 to Claim 13, wherein the conductive layer is configured of at least one metal selected from a group consisting of Al, Ag, Au and, Cu, or an alloy thereof.

15. The photodiode as claimed in one of Claim 1 to Claim 14, wherein a junction area in the photodiode is 100 square microns or less.

16. The photodiode as claimed in one of Claim 1 to Claim 14, wherein a junction area in the photodiode is 10 square microns or less.

17. The photodiode as claimed in one of Claim 1 to Claim 14, wherein a junction area in the photodiode is one square micron or less.

18. The photodiode as claimed in one of Claim 1 to Claim 17, wherein a thickness of the semiconductor absorption layer in the photodiode is 1 $\mu$m or less.

19. The photodiode as claimed in one of Claim 1 to Claim 17, wherein a thickness of the semiconductor absorption layer in the photodiode is 200 nm or less.

20. The photodiode as claimed in one of Claim 1 to Claim 19, wherein the semiconductor absorption layer in the photodiode is configured of at least one member selected from a group consisting of Si, SixGel-x (where x is a positive number less than 1), Ge, GaN, GaAs, GaInAs, GaInP, and InP.

21. The photodiode as claimed in one of Claim 1 to Claim 20:
wherein the semiconductor absorption layer in the photodiode is configured of at least one member selected from a group consisting of Ge, and SixGel-x (where x is a positive number less than 1); and
wherein a layer comprised of an alloy of Ni and Ge is formed between said semiconductor absorption layer and the conductive layer.

22. The photodiode as claimed in one of Claim 1 to Claim 21, said photodiode configured on an optical waveguide comprised of the semiconductor.

23. The photodiode as claimed in one of Claim 1 to Claim 21, said photodiode configured so that it can receives the light from the optical waveguide formed on a substrate side, said light reflected by a mirror.

24. The photodiode as claimed in one of Claim 1 to Claim 23, wherein a substrate of the photodiode is configured of a material transparent to the incident light.

25. An optical communication device, wherein any of the photodiodes of Claim 1 to Claim 24 is formed on a light receiving portion.

26. An optical interconnection module, comprising:

a Si substrate having any of the photodiodes of Claim 1 to Claim 24 configured thereon; and
an LSI electronic circuit formed monolithically with said photodiode on said Si substrate.


**Amended claims under Art. 19.1 PCT**

1. (Amended) A Schottky barrier type photodiode having a conductive layer formed on a surface of a semiconductor layer:
wherein a periodic structure for causing a surface plasmon resonance is formed adjacently to said conductive layer in a circumference of a Schottky junction of said photodiode;
wherein said semiconductor layer is formed on a surface in which said periodic structure of said conductive layer has been formed;
wherein a dielectric layer of which a refractive index is lower than that of said semiconductor layer is formed around said semiconductor layer; and
wherein said photodiode is configured so that light can be incident on a surface in which said periodic structure has been made.

2. (Amended) A p-i-n type photodiode having a p-i-n type junction formed on a surface of a semiconductor layer:
   wherein a conductive layer is formed and a periodic structure for causing a surface plasmon resonance is formed adjacently to said conductive layer in a circumference of the p-i-n junction of said photodiode;
   wherein said semiconductor layer is formed on a surface in which said periodic structure of said conductive layer has been formed;
   wherein a dielectric layer of which a refractive index is lower than that of said semiconductor layer is formed around said semiconductor layer; and
   wherein said photodiode is configured so that light can be incident on a surface in which said periodic structure has been made.

3. (Amended) A photodiode having metal-semiconductor-metal junctions intervally arranged on a surface of a semiconductor layer:
   wherein a conductive layer is formed and a periodic structure for causing a surface plasmon resonance is formed adjacently to said conductive layer in a circumference of the metal-semiconductor-metal junction of said photodiode;
   wherein said semiconductor layer is formed on a surface in which said periodic structure of said conductive layer has been formed;
   wherein a dielectric layer of which a refractive index is lower than that of said semiconductor layer is formed around said semiconductor layer; and
   wherein said photodiode is configured so that light can be incident on a surface in which said periodic structure has been made.

4. The photodiode as claimed in Claim 3;
   wherein an interval of the metal-semiconductor-metal junctions arranged on the surface of the semiconductor layer is equal to or less than $\lambda/n$ (where $\lambda$: a wavelength of the light incident from the back side of the semiconductor layer, and n: a refractive index of the light in the semiconductor layer); and
   wherein said metal layer is a layer in which a metal layer forming a Schottky junction with said semiconductor, and a layer comprised of a conductive material capable of inducing a surface plasmon have been laminated, or a metal layer capable of forming the Schottky junction with said semiconductor, and yet of inducing the surface plasmon.

# FIG. 1

9 PERIODIC ROUGHNESS

1 SEMICONDUCTOR ABSORPTION LAYER

2 CONDUCTIVE FILM

7 OXIDE FILM

5 LOAD RESISTANCE

6 BIAS POWER SOURCE

3 LOWER ELECTRODE LAYER    8 SUPPORT SUBSTRATE    4 BURIED OXIDE LAYER

INCIDENT LIGHT

# FIG. 2

10 SCHOTTKY CONTACT LAYER

9 PERIODIC ROUGHNESS

1 SEMICONDUCTOR ABSORPTION LAYER

2 CONDUCTIVE FILM

7 OXIDE FILM

5 LOAD RESISTANCE

6 BIAS POWER SOURCE

8 SUPPORT SUBSTRATE

3 LOWER ELECTRODE LAYER

INCIDENT LIGHT

# FIG. 3

11 p$^+$ ELECTRODE LAYER

9 PERIODIC ROUGHNESS

1 SEMICONDUCTOR ABSORPTION LAYER (i LAYER)

2 CONDUCTIVE FILM

7 OXIDE FILM

5 LOAD RESISTANCE

6 BIAS POWER SOURCE

12 n$^+$ ELECTRODE LAYER

8 SUPPORT SUBSTRATE

4 BURIED OXIDE LAYER

INCIDENT LIGHT

EP 2 110 864 A1

# FIG. 4

9 PERIODIC ROUGHNESS

13 MSM ELECTRODE

1 SEMICONDUCTOR ABSORPTION LAYER

2 CONDUCTIVE FILM

7 OXIDE FILM

5 LOAD RESISTANCE

6 BIAS POWER SOURCE

8 SUPPORT SUBSTRATE

4 BURIED OXIDE LAYER

INCIDENT LIGHT

EP 2 110 864 A1

## FIG. 5

18  SCHOTTKY CONTACT PORTION

2  CONDUCTIVE FILM

9  PERIODIC ROUGHNESS

## FIG. 6

14  FORBIDDEN BAND GRATING FOR
PREVENTING PLASMON
RESONANCE FROM BEING
GENERATED

18  SCHOTTKY CONTACT
PORTION

2  CONDUCTIVE FILM

9  PERIODIC ROUGHNESS

# FIG. 7

18 SCHOTTKY CONTACT PORTION

15 PROJECTED
SHAPE

2 CONDUCTIVE FILM

9 PERIODIC ROUGHNESS

# FIG. 8

18 SCHOTTKY CONTACT PORTION

16 GROOVED SHAPE

2 CONDUCTIVE FILM

9 PERIODIC ROUGHNESS

# FIG. 9

17 PERIODIC SLIT ARRAY

18 SCHOTTKY CONTACT PORTION

2 CONDUCTIVE FILM

9 PERIODIC ROUGHNESS

# FIG. 10

17 ARRAY OF PENETRATED HOLES    18 SCHOTTKY CONTACT PORTION

2 CONDUCTIVE FILM

9 PERIODIC ROUGHNESS

FIG. 11

# FIG. 12

(a)

1 SEMICONDUCTOR ABSORPTION LAYER
3 LOWER ELECTRODE LAYER
4 BURIED OXIDE LAYER
8 SUPPORT SUBSTRATE

(b) SiN$_x$ MASK スク

7 OXIDE FILM
1 SEMICONDUCTOR ABSORPTION LAYER
3 LOWER ELECTRODE LAYER
4 BURIED OXIDE LAYER
8 SUPPORT SUBSTRATE

(c)

7 OXIDE FILM
1 SEMICONDUCTOR ABSORPTION LAYER
3 LOWER ELECTRODE LAYER
4 BURIED OXIDE LAYER
8 SUPPORT SUBSTRATE

(d)  9 PERIODIC ROUGHNESS

7 OXIDE FILM
1 SEMICONDUCTOR ABSORPTION LAYER
3 LOWER ELECTRODE LAYER
4 BURIED OXIDE LAYER
8 SUPPORT SUBSTRATE

(e)  2 CONDUCTIVE FILM

7 OXIDE FILM
1 SEMICONDUCTOR ABSORPTION LAYER
3 LOWER ELECTRODE LAYER
4 BURIED OXIDE LAYER
8 SUPPORT SUBSTRATE

9 PERIODIC ROUGHNESS

## FIG. 13

## FIG. 14

## FIG. 15

7 OXIDE FILM   1 SEMICONDUCTOR ABSORPTION LAYER   21 ELECTRODE PAD

5 LOAD RESISTANCE

6 BIAS POWER SOURCE

9 PERIODIC ROUGHNESS (BACK SIDE)

2 MSM ELECTRODE

14 FORBIDDEN BAND GRATING FOR PREVENTING PLASMON RESONANCE FROM BEING GENERATED (BACK SIDE)

## FIG. 16

WITH PERIODIC ROUGHNESS

WITHOUT PERIODIC ROUGHNESS

DARK CURRENT

PHOTOCURRENT (A)

BIAS VOLTAGE (V)

# FIG. 17

14 FORBIDDEN BAND GRATING FOR PREVENTING
PLASMON RESONANCE FROM BEING GENERATED

1 SEMICONDUCTOR
ABSORPTION
LAYER

9 PERIODIC ROUGHNESS

2 CONDUCTIVE FILM

5 LOAD
RESISTANCE

7 OXIDE FILM

6 BIAS POWER
SOURCE

3 LOWER
ELECTRODE
LAYER

8 SUPPORT
SUBSTRATE

4 BURIED OXIDE
LAYER

INCIDENT LIGHT

# FIG. 18

15
PROJECTED
SHAPE

1 SEMICONDUCTOR
ABSORPTION
LAYER

9 PERIODIC ROUGHNESS

2 CONDUCTIVE FILM

5 LOAD
RESISTANCE

7 OXIDE FILM

6 BIAS POWER
SOURCE

3 LOWER
ELECTRODE
LAYER

8 SUPPORT
SUBSTRATE

4 BURIED OXIDE
LAYER

INCIDENT LIGHT

# FIG. 19

16 GROOVED SHAPE

1 SEMICONDUCTOR ABSORPTION LAYER

9 PERIODIC ROUGHNESS

2 CONDUCTIVE FILM

5 LOAD RESISTANCE

6 BIAS POWER SOURCE

7 OXIDE FILM

3 LOWER ELECTRODE LAYER

8 SUPPORT SUBSTRATE

4 BURIED OXIDE LAYER

INCIDENT LIGHT

# FIG. 20

17 PERIODIC SLIT ARRAY OR MINUTE APERTURE ARRAY

1 SEMICONDUCTOR ABSORPTION LAYER

9 PERIODIC ROUGHNESS

2 CONDUCTIVE FILM

5 LOAD RESISTANCE

6 BIAS POWER SOURCE

7 OXIDE FILM

3 LOWER ELECTRODE LAYER

8 SUPPORT SUBSTRATE

4 BURIED OXIDE LAYER

INCIDENT LIGHT

FIG. 21

26 CHIP CARRIER

25 PREAMP IC

24 ELECTRIC WIRING

23 MODULE FRAME

21 SIGNAL LIGHT

22 PHOTODIODE IN ACCORDANCE WITH THE PRESENT INVENTION

20 OPTICAL FIBER

FIG. 22

## INTERNATIONAL SEARCH REPORT

| | International application No. |
|---|---|
| | PCT/JP2007/072904 |

A. CLASSIFICATION OF SUBJECT MATTER
*H01L31/108*(2006.01)i, *H01L31/105*(2006.01)i, *H01L31/0224*(2006.01)i

According to International Patent Classification (IPC) or to both national classification and IPC

B. FIELDS SEARCHED

Minimum documentation searched (classification system followed by classification symbols)
H01L31/10-31/119, G02F1/00-1/125

Documentation searched other than minimum documentation to the extent that such documents are included in the fields searched
Jitsuyo Shinan Koho      1922-1996   Jitsuyo Shinan Toroku Koho   1996-2007
Kokai Jitsuyo Shinan Koho   1971-2007   Toroku Jitsuyo Shinan Koho   1994-2007

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | WO 2005/098966 A1 (NEC Corp.), 20 October, 2005 (20.10.05), Par. Nos. [0018], [0022], [0065], [0092]; Figs. 4, 15, 19 (Family: none) | 1-26 |
| Y | JP 2-129616 A (International Business Machines Corp.), 17 May, 1990 (17.05.90), Examples; Fig. 1 & US 4915482 A      & EP 0365766 A2 | 1-26 |

☒ Further documents are listed in the continuation of Box C.    ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 14 December, 2007 (14.12.07) | 25 December, 2007 (25.12.07) |

| Name and mailing address of the ISA/ | Authorized officer |
|---|---|
| Japanese Patent Office | |
| Facsimile No. | Telephone No. |

Form PCT/ISA/210 (second sheet) (April 2007)

35

EP 2 110 864 A1

**INTERNATIONAL SEARCH REPORT**

International application No.

PCT/JP2007/072904

C (Continuation). DOCUMENTS CONSIDERED TO BE RELEVANT

| Category* | Citation of document, with indication, where appropriate, of the relevant passages | Relevant to claim No. |
|---|---|---|
| Y | JP 8-204226 A (Director General, Agency of Industrial Science and Technology), 09 August, 1996 (09.08.96), Par. No. [0004] & US 5661328 A & US 5895227 A & US 5945720 A & EP 0723302 A2 & EP 0926742 A2 | 3-5 |
| Y | WO 2005/029164 A1 (NEC Corp.), 31 March, 2005 (31.03.05), Claim 2; Abstract; Figs. 1, 3 & EP 1672409 A1 | 8-14 |
| A | Tsutomu Ishi, et al. 'Si Nano-Photodiode with a Surface Plasmon Antenna' Japanese Journal of Applied Physics, 2005, Vol.44, No.12, pp.L364-366 | 1-26 |
| A | JP 10-509806 A (PAINTER, Bland, A., III), 22 September, 1998 (22.09.98), Full text; all drawings & US 5625729 A & WO 1996/005536 A2 | 3-5 |
| A | JP 4-171405 A (Honda Motor Co., Ltd.), 18 June, 1992 (18.06.92), Full text; all drawings (Family: none) | 3-5 |
| A | JP 2005-338166 A (NEC Corp.), 08 December, 2005 (08.12.05), Full text; all drawings (Family: none) | 8-14 |

Form PCT/ISA/210 (continuation of second sheet) (April 2007)

EP 2 110 864 A1

# INTERNATIONAL SEARCH REPORT

International application No.

PCT/JP2007/072904

**Box No. II    Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III    Observations where unity of invention is lacking (Continuation of item 3 of first sheet)**

This International Searching Authority found multiple inventions in this international application, as follows:

    The matter common to the inventions of claims 1 - 26 resides in the point that a plasmon antenna is formed in the periphery of a light receiving portion of a surface thereby to make the light incident on the back. However, that common matter has no inventive step, because its difference from Document 1 (WO2005/098966A1) cited in the International Searching Report is only the incidence direction of light.
    Thus, the claim 1 relates to a Schottky type, claim 2 relates to a pin type, claims 3 - 5 relate to an MSM type, claims 6 - 14 relate a periodic structure for a plasmon resonance, claims 15 - 21 relate to the size and material of a light receiving unit, (continued to extra sheet)

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**    ☐ The additional search fees were accompanied by the applicant's protest and, where applicable,
the                             payment of a protest fee.

                               ☐ The additional search fees were accompanied by the applicant's protest but the applicable protest
                               fee was not paid within the time limit specified in the invitation.

                               ☐ No protest accompanied the payment of additional search fees.

Form PCT/ISA/210 (continuation of first sheet (2)) (April 2007)

| **INTERNATIONAL SEARCH REPORT** | International application No. |
|---|---|
| | PCT/JP2007/072904 |

Continuation of Box No.III of continuation of first sheet(2)

and claims 22 - 26 relate to the constitution other than the aforementioned ones. Therefore, these claims do not involve the same or corresponding special technical features within the meaning of PCT Rule 13.2, second sentence. Hence, the present patent application does not comply with the requirement of unity of invention.

Form PCT/ISA/210 (extra sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP P1984108376 A
- WO 2666888 A
- WO 2705757 A
- JP P1998509806 A
- JP P200276410 A
- JP P2000171763 A
- JP P2005150291 A
- JP P199477518 A
- JP 2006342336 A

**Non-patent literature cited in the description**

- **Tineke Thio ; H.J. Lezec ; T. W. Ebbesen ; K. M. Pellerin ; G. D. Lewen ; A. Nahata ; R. A. Linke.** Giant optical transmission of sub-wavelength apertures: physics and applications. *Nanotechnology,* vol. 13, 429-432
- **S. J. Koester ; G. Dehlinger ; J. D. Schaub ; J. O. Chu ; Q. C. Quyang ; A. Grill.** Germanium-on-Insulator Photodetectors. *2nd International Conference on Group IV Photonics, FBI,* 2005